# EUROPÄISCHE PATENTSCHRIFT

(11) **EP 3 135 076 B1**
(45) Veröffentlichungstag und Bekanntmachung des Hinweises auf die Patenterteilung: **14.08.2019**
(21) Anmeldenummer: 15719434.1
(22) Anmeldetag: 21.04.2015
(51) Int. Cl.: H05B 3/84, H03K 17/96, B32B 17/10

(54) **SCHEIBE MIT BELEUCHTETER SCHALTFLÄCHE UND HEIZFUNKTION**
PANE WITH ILLUMINATED SWITCH BUTTON AND HEATING FUNCTION
VITRE COMPRENANT UN BOUTON LUMINEUX ET UNE FONCTION DE CHAUFFAGE

(30) Priorität: 24.04.2014 US 201461983669 P
(43) Veröffentlichungstag der Anmeldung: 01.03.2017
(73) Patentinhaber: Saint-Gobain Glass France, 92400 Courbevoie (FR)
(72) Erfinder: WEBER, Patrick, 52477 Alsdorf (DE); SCHULZ, Valentin, 52382 Niederzier (DE); HERMANGE, Francois, 52074 Aachen (DE); DROSTE, Stefan, 52134 Herzogenrath (DE); BONDKOWSKI, Jens, 75013 Paris (FR); PARIJ, Gerry, Warren, Michigan 48092 (US)
(74) Vertreter: Gebauer, Dieter Edmund
(86) Internationale Anmeldenummer: PCT/EP2015/058552
(87) Internationale Veröffentlichungsnummer: WO 2015/162107

(56) Entgegenhaltungen:
- WO-A1-2008/113978
- WO-A1-2013/091961
- DE-U1-202009 017 952

## Beschreibung

Die Erfindung betrifft eine Scheibe mit beleuchteter Schaltfläche und Heizfunktion, ein Verfahren zu ihrer Herstellung und ihre Verwendung.

Es ist bekannt, dass Schaltflächen durch eine Flächenelektrode oder durch eine Anordnung von zwei gekoppelten Elektroden ausgebildet werden können, beispielsweise als kapazitive Schaltflächen. Nähert sich ein Objekt der Schaltfläche, so ändert sich die Kapazität der Flächenelektrode gegen Erde oder die Kapazität des von den zwei gekoppelten Elektroden gebildeten Kondensators. Die Kapazitätsänderung wird über eine Schaltungsanordnung gemessen und bei Überschreiten eines Schwellwerts wird ein Schaltsignal ausgelöst. Schaltungsanordnungen für kapazitive Schalter sind beispielsweise aus DE 20 2006 006 192 U1, EP 0 899 882 A1, US 6,452,514 B1 und EP 1 515 211 A1 bekannt.

Die Elektrode oder die Elektroden können direkt auf einer Scheibe aus Glas oder einem anderen transparenten Material aufgebracht sein, was beispielsweise aus EP 1 544 178 A1 bekannt ist. Die Schaltfläche kann so ohne weitere Bauelemente in eine Verglasung integriert werden. Die Schaltfläche ist dabei allerdings nicht oder nur schwer zu erkennen. Bei Dunkelheit kann die Schaltfläche zudem nicht ertastet werden. Daher muss die Position der Schaltfläche markiert werden, wobei die Markierung insbesondere auch bei Dunkelheit wahrnehmbar sein muss.

DE 20 2009 017952 U1 zeigt eine Verglasung, bei welcher eine Schaltfläche durch luminszeszierende Pigmente markierbar ist.

WO 2008/113978 A1 zeigt eine Verglasung, bei welcher eine Schaltfläche durch in die Zwischenschicht integrierte LEDs markierbar ist.

Die Aufgabe der vorliegenden Erfindung ist eine verbesserte Scheibe mit integrierter Schaltfläche, Beleuchtung und Heizfunktion und ein Verfahren zu ihrer Herstellung bereitzustellen.

Die Aufgabe der vorliegenden Erfindung wird erfindungsgemäß durch eine Scheibe mit beleuchteter Schaltfläche gemäß dem unabhängigen Anspruch 1 gelöst. Bevorzugte Ausführungen gehen aus den Unteransprüchen hervor.

Die erfindungsgemäße Scheibe mit beleuchteter Schaltfläche umfasst die folgenden Merkmale:
- ein transparentes Substrat,
- einen Heizbereich, der mit mindestens zwei zum Anschluss an eine Spannungsquelle vorgesehene Sammelleiter so verbunden ist, dass zwischen den Sammelleitern ein Strompfad für einen Heizstrom geformt ist,
- eine elektrisch leitfähige Struktur, die eine Schaltfläche ausbildet und die mit einer Sensorelektronik verbindbar ist und
- ein Beleuchtungsmittel, mit dem die Schaltfläche markierbar ist.

Das transparente Substrat enthält bevorzugt vorgespanntes, teilvorgespanntes oder nichtvorgespanntes Glas, besonders bevorzugt Flachglas, Floatglas, Quarzglas, Borosilikatglas, Kalk-Natron-Glas, oder klare Kunststoffe, insbesondere Polyethylen, Polypropylen, Polycarbonat, Polymethylmethacrylat, Polystyrol, Polyamid, Polyester, Polyvinylchlorid und/oder Gemische davon.

Die Dicke des Substrats kann breit variieren und so hervorragend den Erfordernissen des Einzelfalls angepasst werden. Das Substrat weist bevorzugt eine Dicke von 0,7 mm bis 10 mm und besonders bevorzugt von 1 mm bis 5 mm auf. Die Fläche des Substrats kann breit variieren, beispielsweise von 100 cm² bis 18 m². Bevorzugt weist das Substrat eine Fläche von 400 cm² bis 4 m² auf, wie sie für Verglasungen von Fahrzeugen und von Bau- und Architekturverglasungen üblich sind.

Erfindungsgemäß ist das Substrat Teil einer Verbundscheibe, insbesondere eines Verbundsicherheitsglases. Dabei ist das Substrat über mindestens eine Zwischenschicht mit zumindest einer Deckscheibe verbunden. Die Zwischenschicht enthält vorzugsweise mindestens einen thermoplastischen Kunststoff, bevorzugt Polyvinylbutyral (PVB), Ethylenvinylacetat (EVA) und/oder Polyethylenterephthalat (PET). Die thermoplastische Zwischenschicht kann aber auch beispielsweise Polyurethan (PU), Polypropylen (PP), Polyacrylat, Polyethylen (PE), Polycarbonat (PC), Polymethylmetacrylat, Polyvinylchlorid, Polyacetatharz, Gießharze, Acrylate, fluorinierte Ethylen-Propylene, Polyvinylfluorid und/oder Ethylen-Tetrafluorethylen, oder Copolymere oder Gemische davon enthalten. Die thermoplastische Zwischenschicht kann durch eine oder auch durch mehrere übereinander angeordnete thermoplastische Folien ausgebildet werden, wobei die Dicke einer thermoplastischen Folie bevorzugt von 0,25 mm bis 1 mm beträgt, typischerweise 0,38 mm oder 0,76 mm.

Die Deckscheibe enthält bevorzugt vorgespanntes, teilvorgespanntes oder nichtvorgespanntes Glas, besonders bevorzugt Flachglas, Floatglas, Quarzglas, Borosilikatglas, Kalk-Natron-Glas, oder klare Kunststoffe, insbesondere Polyethylen, Polypropylen, Polycarbonat, Polymethylmethacrylat, Polystyrol, Polyamid, Polyester, Polyvinylchlorid und/oder Gemische davon. Die Deckscheibe weist bevorzugt eine Dicke von 0,3 mm bis 10 mm und besonders bevorzugt von 0,7 mm bis 3 mm auf.

Als transparent im Sinne der Erfindung wird dann eine Scheibe, ein Substrat, eine Deckscheibe oder eine Schicht verstanden, wenn die Transmission im sichtbaren Spektralbereich von größer 70 % ist. Für Scheiben, die nicht im verkehrsrelevanten Sichtfeld des Fahrers liegen, beispielsweise für Dachscheiben, kann die Transmission aber auch viel geringer sein, beispielsweise größer als 5 %.

Der Heizbereich ist mit mindestens zwei zum Anschluss an eine Spannungsquelle vorgesehenen Sammelleiter so verbunden, dass zwischen den Sammelleitern ein Strompfad für einen Heizstrom geformt ist.

In einer vorteilhaften Ausgestaltung eines erfindungsgemäßen Heizbereichs weist der Heizbereich eine Vielzahl einzelner metallischer Drähte, sogenannter Heizdrähte, auf, die jeweils die Sammelleiter miteinander verbinden. Die Strompfade und der Heizstrom verlaufen dann entlang der einzelnen Drähte. Die Drähte sind vorteilhafterweise sehr dünn ausgebildet, so dass sie die Durchsicht durch die Scheibe nicht oder nur geringfügig beeinträchtigen. Bevorzugte Drähte weisen eine Dicke von weniger als oder gleich 0,1 mm, besonders bevorzugt von 0,02 mm bis 0,04 mm und insbesondere von 0,024 mm bis 0,029 mm auf. Die metallischen Drähte enthalten bevorzugt Kupfer, Wolfram, Gold, Silber oder Aluminium oder Legierungen mindestens zweier dieser Metalle. Die metallischen Drähte bestehen besonders bevorzugt aus Kupfer, Wolfram, Gold, Silber oder Aluminium oder Legierungen mindestens zweier dieser Metalle. Die Legierungen können auch Molybdän, Rhenium, Osmium, Iridium, Palladium oder Platin enthalten.

In einer alternativen vorteilhaften Ausgestaltung der erfindungsgemäßen Scheibe enthält der Heizbereich dünne gedrückte Heizstrukturen aus einem elektrisch leitfähigen Material, beispielsweise eine eingebrannte Druckpaste mit Metallpartikeln.

In einer weiteren alternativen, vorteilhaften Ausgestaltung eines erfindungsgemäßen Heizbereichs weist der Heizbereich eine transparente, elektrisch leitfähige Schicht auf. Insbesondere kann der Heizbereich ein Teilbereich einer transparenten, elektrisch leitfähigen Schicht sein, die beispielsweise noch andere elektrisch leitfähige Strukturen umfasst, die von dem Heizbereich elektrisch isoliert sind.

Die elektrisch leitfähige Schicht enthält bevorzugt eine transparente, elektrisch leitfähige Beschichtung. Erfindungsgemäße elektrisch leitfähige Schichten sind beispielsweise aus DE 20 2008 017 611 U1, EP 0 847 965 B1 oder WO2012/052315 A1 bekannt. Sie enthalten typischerweise eine oder mehrere, beispielsweise zwei, drei oder vier elektrisch leitfähige, funktionelle Schichten. Die funktionellen Schichten enthalten bevorzugt zumindest ein Metall, beispielsweise Silber, Gold, Kupfer, Nickel und oder Chrom, oder eine Metalllegierung. Die funktionellen Schichten enthalten besonders bevorzugt mindestens 90 Gew.-% des Metalls, insbesondere mindestens 99,9 Gew.-% des Metalls. Die funktionellen Schichten können aus dem Metall oder der Metalllegierung bestehen. Die funktionellen Schichten enthalten besonders bevorzugt Silber oder eine silberhaltige Legierung. Solche funktionelle Schichten weisen eine besonders vorteilhafte elektrische Leitfähigkeit bei gleichzeitiger hoher Transmission im sichtbaren Spektralbereich auf. Die Dicke einer funktionellen Schicht beträgt bevorzugt von 5 nm bis 50 nm, besonders bevorzugt von 8 nm bis 25 nm. In diesem Bereich für die Dicke der funktionellen Schicht wird eine vorteilhaft hohe Transmission im sichtbaren Spektralbereich und eine besonders vorteilhafte elektrische Leitfähigkeit erreicht.

Typischerweise ist jeweils zwischen zwei benachbarten funktionellen Schichten der beheizbaren Beschichtung zumindest eine dielektrische Schicht angeordnet. Bevorzugt ist unterhalb der ersten und/oder oberhalb der letzten funktionellen Schicht eine weitere dielektrische Schicht angeordnet. Eine dielektrische Schicht enthält zumindest eine Einzelschicht aus einem dielektrischen Material, beispielsweise enthaltend ein Nitrid wie Siliziumnitrid oder ein Oxid wie Aluminiumoxid. Dielektrische Schicht können aber auch mehrere Einzelschichten umfassen, beispielsweise Einzelschichten eines dielektrischen Materials, Glättungsschichten, Anpassungsschichten, Blockerschichten und/oder Antireflexionsschichten. Die Dicke einer dielektrischen Schicht beträgt beispielsweise von 10 nm bis 200 nm.

Dieser Schichtaufbau wird im Allgemeinen durch eine Folge von Abscheidevorgängen erhalten, die durch ein Vakuumverfahren wie die magnetfeldgestützte Kathodenzerstäubung durchgeführt werden.

Weitere geeignete elektrisch leitfähige Schichten enthalten bevorzugt Indium-Zinnoxid (ITO), fluordotiertes Zinnoxid (SnO₂:F) oder aluminiumdotiertes Zinkoxid (ZnO:AI).

Die elektrisch leitfähige Schicht kann prinzipiell jede Beschichtung sein, die elektrisch kontaktiert werden kann. Soll die erfindungsgemäße Scheibe die Durchsicht ermöglichen, wie es beispielsweise bei Scheiben im Fensterbereich der Fall ist, so ist die elektrisch leitfähige Schicht bevorzugt transparent. In einer vorteilhaften Ausgestaltung ist die elektrisch leitfähige Schicht eine Schicht oder ein Schichtaufbau mehrerer Einzelschichten mit einer Gesamtdicke von kleiner oder gleich 2 µm, besonders bevorzugt kleiner oder gleich 1 µm.

Eine vorteilhafte erfindungsgemäße elektrisch leitfähige Schicht weist einen Flächenwiderstand von 0,4 Ohm/Quadrat bis 10 Ohm/Quadrat auf. In einer besonders bevorzugten Ausgestaltung weist die erfindungsgemäße elektrisch leitfähige Schicht einen Flächenwiderstand von 0,5 Ohm/Quadrat bis 1 Ohm/Quadrat auf. Beschichtungen mit derartigen Flächenwiderständen eignen sich besonders zur Beheizung von Fahrzeugscheiben bei typischen Bordspannungen von 12 V bis 48 Volt oder bei Elektrofahrzeugen mit typischen Bordspannungen von bis zu 500 V.

Die elektrisch leitfähige Schicht kann sich über die gesamte Oberfläche des Substrats erstrecken. Die elektrisch leitfähige Schicht kann sich alternativ aber auch nur über einen Teil der Oberfläche des Substrats erstrecken. Die elektrisch leitfähige Schicht erstreckt sich bevorzugt über mindestens 50%, besonders bevorzugt über mindestens 70% und ganz besonders bevorzugt über mindestens 90% der innenseitigen Oberfläche des Substrats. Die elektrisch leitfähige Schicht kann eine oder mehrere unbeschichtete Zonen aufweisen. Diese Zonen können für elektromagnetische Strahlung durchlässig sein und sind beispielsweise als Datenübertragungsfenster oder Kommunikationsfenster bekannt.

In einer vorteilhaften Ausgestaltung einer erfindungsgemäßen Scheibe als Verbundscheibe weist die innenseitige Oberfläche des Substrats einen umlaufenden Randbereich mit einer Breite von 2 mm bis 50 mm, bevorzugt von 5 mm bis 20 mm auf, der nicht mit der elektrisch leitfähige Schicht versehen ist. Die elektrisch leitfähige Schicht weist dann keinen Kontakt zur Atmosphäre auf und ist im Inneren der Scheibe durch die thermoplastische Zwischen-schicht vorteilhaft vor Beschädigungen und Korrosion geschützt.

Der Heizbereich weist mindestens zwei zum Anschluss an eine Spannungsquelle vorgesehene Sammelleiter auf und ist mit ihnen so verbunden, dass zwischen den Sammelleitern ein Strompfad für einen Heizstrom geformt ist und insbesondere ein Heizstrom fließt, wenn eine Spannung anliegt.

Die Sammelleiter sind bevorzugt entlang der Seitenkante der elektrisch leitfähigen Schicht angeordnet. Die Länge des Sammelleiters ist typischerweise im Wesentlichen gleich der Länge der Seitenkante der elektrisch leitfähigen Schicht, kann aber auch leicht größer oder kleiner sein. Es können auch mehr als zwei Sammelleiter auf der elektrisch leitfähigen Schicht angeordnet sein, bevorzugt im Randbereich entlang zweier gegenüberliegenden Seitenkanten der elektrisch leitfähigen Schicht. Es können auch mehr als zwei Sammelleiter auf der elektrisch leitfähigen Schicht angeordnet sein, beispielsweise um zwei oder mehrere unabhängige Heizbereiche in einer Schicht auszubilden oder wenn der Sammelleiter durch eine oder mehrere unbeschichtete Zonen wie Kommunikationsfenster unterbrochen oder versetzt ist. Die erfindungsgemäße Lehre gilt dann für mindestens einen und bevorzugt für jeden der unabhängigen Heizbereiche.

In einer vorteilhaften Ausgestaltung ist der erfindungsgemäße Sammelleiter als aufgedruckte und eingebrannte leitfähige Struktur ausgebildet. Der aufgedruckte Sammelleiter enthält bevorzugt zumindest ein Metall, eine Metalllegierung, eine Metallverbindung und/oder Kohlenstoff, besonders bevorzugt ein Edelmetall und insbesondere Silber. Die Druckpaste enthält bevorzugt metallische Partikel Metallpartikel und/oder Kohlenstoff und insbesondere Edelmetallpartikel wie Silberpartikel. Die elektrische Leitfähigkeit wird bevorzugt durch die elektrisch leitenden Partikel erzielt. Die Partikel können sich in einer organischen und/oder anorganischen Matrix wie Pasten oder Tinten befinden, bevorzugt als Druckpaste mit Glasfritten.

Die Breite des ersten und zweiten Sammelleiters beträgt bevorzugt von 2 mm bis 30 mm, besonders bevorzugt von 4 mm bis 20 mm und insbesondere von 10 mm bis 20 mm. Dünnere Sammelleiter führen zu einen zu hohen elektrischen Widerstand und damit zu einer zu hohen Erwärmung des Sammelleiters im Betrieb. Des Weiteren sind dünnere Sammelleiter nur schwer durch Drucktechniken wie Siebdruck herzustellen. Dickere Sammelleiter erfordern einen unerwünscht hohen Materialeinsatz. Des Weiteren führen sie zu einer zu großen und unästhetischen Einschränkung des Durchsichtbereichs der Scheibe. Die Länge des Sammelleiters richtet sich nach der Ausdehnung des Heizbereichs. Bei einem Sammelleiter, der typischerweise in Form eines Streifens ausgebildet ist, wird die längere seiner Dimensionen als Länge und die weniger lange seiner Dimensionen als Breite bezeichnet. Die dritten oder zusätzlichen Sammelleiter können auch dünner ausgestaltet sein, bevorzugt von 0,6 mm bis 5 mm.

Die Schichtdicke des aufgedruckten Sammelleiters beträgt bevorzugt von 5 µm bis 40 µm, besonders bevorzugt von 8 µm bis 20 µm und ganz besonders bevorzugt von 8 µm bis 12 µm. Aufgedruckte Sammelleiter mit diesen Dicken sind technisch einfach zu realisieren und weisen eine vorteilhafte Stromtragfähigkeit auf.

Der spezifische Widerstand ρₐ der Sammelleiter beträgt bevorzugt von 0.8 µOhm•cm bis 7.0 µOhm•cm und besonders bevorzugt von 1.0 µOhm•cm bis 2.5 µOhm•cm. Sammelleiter mit spezifischen Widerständen in diesem Bereich sind technisch einfach zu realisieren und weisen eine vorteilhafte Stromtragfähigkeit auf.

Alternativ kann der Sammelleiter aber auch als Streifen einer elektrisch leitfähigen Folie ausgebildet sein. Der Sammelleiter enthält dann beispielsweise zumindest Aluminium, Kupfer, verzinntes Kupfer, Gold, Silber, Zink, Wolfram und/oder Zinn oder Legierungen davon. Der Streifen hat bevorzugt eine Dicke von 10 µm bis 500 µm, besonders bevorzugt von 30 µm bis 300 µm. Sammelleiter aus elektrisch leitfähigen Folien mit diesen Dicken sind technisch einfach zu realisieren und weisen eine vorteilhafte Stromtragfähigkeit auf. Der Streifen kann mit der elektrisch leitfähigen Struktur beispielsweise über eine Lotmasse, über einen elektrisch leitfähigen Kleber oder durch direktes Auflegen elektrisch leitend verbunden sein.

Die erfindungsgemäße Scheibe umfasst vorteilhafterweise ein Substrat, auf der eine beheizbare elektrisch leitfähige Schicht angeordnet ist. Je nach Art der Schicht ist es vorteilhaft die Schicht mit einer Schutzschicht, beispielsweise einem Lack, einer Polymerfolie und/oder einer Deckscheibe zu schützen.

In einer vorteilhaften Ausgestaltung der erfindungsgemäßen Scheibe enthält die elektrisch leitfähige Struktur mindestens ein linienförmiges, elektrisch leitfähiges Element. Das linienförmige, elektrisch leitfähige Element ist bevorzugt ein elektrisch leitfähiger Draht. Der Draht ist vorteilhafterweise sehr dünn ausgebildet, so dass er die Durchsicht durch die Scheibe nicht oder nur geringfügig beeinträchtigt. Bevorzugte Drähte weisen eine Dicke von weniger als oder gleich 0,25 mm, besonders bevorzugt von 0,02 mm bis 0,15 mm auf. Die Drähte sind bevorzugt metallisch enthalten insbesondere Kupfer, Wolfram, Gold, Silber oder Aluminium oder Legierungen mindestens zweier dieser Metalle oder bestehen daraus. Die Legierungen können auch Molybdän, Rhenium, Osmium, Iridium, Palladium oder Platin enthalten.

Der Draht ist bevorzugt elektrisch isoliert, beispielsweise durch eine mantelförmige elektrische Isolierung aus Kunststoff. Dies ist besonders vorteilhaft, wenn der Draht auf der elektrisch leitfähigen Schicht verläuft oder andere elektrisch leitende und/oder spannungsführende Elemente der Scheibe berührt.

In einer alternativen vorteilhaften Ausgestaltung der erfindungsgemäßen Scheibe enthält die elektrisch leitfähige Struktur mindestens eine dünne gedrückte Struktur aus einem leitfähigen Material, beispielsweise eine eingebrannte Druckpaste mit Metallpartikeln. Die elektrisch leitfähige Struktur kann durch Aufdrucken und Einbrennen einer leitfähigen Paste hergestellt werden. Die leitfähige Paste enthält dabei bevorzugt Silber-Partikel und Glas-fritten. Die Schichtdicke der eingebrannten Paste beträgt bevorzugt von 5 µm bis 40 µm, besonders bevorzugt von 8 µm bis 20 µm. Die eingebrannte Silberpaste weist selbst lichtstreuende Eigenschaft auf und kann daher vorteilhaft selbst als Lichtablenkmittel dienen.

In einer alternativen vorteilhaften Ausgestaltung der erfindungsgemäßen Scheibe enthält die elektrisch leitfähige Struktur eine transparente, elektrisch leitfähige Schicht. Dies ist besonders vorteilhaft, da dann die elektrisch leitfähige Struktur die Durchsicht durch die Scheibe nicht oder nur geringfügig beeinträchtigt. Verschiedene geeignete transparente, elektrisch leitfähige Schichten wurden eingangs als Schichten für den Heizbereich bereits genannt.

Da die elektrisch leitende Struktur der Schaltfläche nur geringe Ströme transportieren muss, kann der Flächenwiderstand der Schicht höher gewählt werden als die elektrisch leitfähige Schicht des Heizbereichs. Eine vorteilhafte erfindungsgemäße elektrisch leitfähige Schicht für die Schaltfläche weist einen Flächenwiderstand von 0,4 Ohm/Quadrat bis 200 Ohm/Quadrat auf.

In einer besonders vorteilhaften Ausgestaltung einer erfindungsgemäßen Scheibe sind die elektrisch leitende Struktur der Schaltfläche und der Heizbereich Teile derselben elektrisch leitfähigen Schicht und sind durch mindestens eine Trennlinie von der transparenten, elektrisch leitfähigen Schicht elektrisch unterteilt. Die Breite d₁ der Trennlinien beträgt bevorzugt von 30 µm bis 200 µm und besonders bevorzugt von 70 µm bis 140 µm. Derartig dünne Trennlinien erlauben eine sichere und ausreichend hohe, elektrische Isolierung und stören gleichzeitig die Durchsicht durch die Scheibe nicht oder nur geringfügig. Die Herstellung der Trennlinien erfolgt bevorzugt durch Laserstrukturierung oder chemisches oder mechanisches Abtragen. Eine derartige Anordnung von Schaltfläche und Heizbereich aus derselben Schicht ist besonders einfach und kostengünstig herzustellen.

Die elektrisch leitfähige Struktur der Schaltfläche weist bevorzugt eine Fläche von 1 cm² bis 200 cm², besonders bevorzugt von 1 cm² bis 10 cm² auf. Die Schaltfläche kann beispielsweise die Form eines Ovals, einer Ellipse oder eines Kreises, eines Dreiecks, eines Rechtecks, eines Quadrats oder eines anders gearteten Vierecks oder eines höheren Polygons aufweisen. Insbesondere sind kreisförmige, elliptische oder tropfenförmige Formen oder Formen mit abgerundeten Ecken sowie Streifenformen besonders vorteilhaft, da dadurch der Heizstrom besonders vorteilhaft um den Umgebungsbereich herum geleitet wird und keine oder nur geringe lokale Überhitzungen, sogenannte Hotspots, auftreten.

Die Schaltfläche ist mit einer Sensorelektronik elektrisch verbindbar, und insbesondere galvanisch, kapazitiv und/oder induktiv verbindbar.

In einer vorteilhaften Ausgestaltung der erfindungsgemäßen Scheibe ist die Schaltfläche eine kapazitive Schaltfläche. Die Schaltfläche bildet dabei eine Flächenelektrode aus. Über eine externe kapazitive Sensorelektronik wird die Kapazität der Flächenelektrode gemessen. Die Kapazität der Flächenelektrode ändert sich gegen Erde, wenn ein geerdeter Körper in ihre Nähe kommt oder beispielsweise eine Isolatorschicht über der Flächenelektrode berührt. Die Isolatorschicht umfasst insbesondere das Substrat selbst oder eine Zwischenschicht oder eine Deckscheibe. Die Kapazitätsänderung wird durch die Sensorelektronik gemessen und bei Überschreiten eines Schwellwerts wird ein Schaltsignal ausgelöst. Der Schaltbereich wird durch Form und Größe der Flächenelektrode festgelegt.

In einer alternativen Ausgestaltung einer erfindungsgemäßen Scheibe, weist die Schalt-fläche zwei elektrisch leitfähige Strukturen auf. Im Falle einer elektrisch leitfähigen Struktur aus einer elektrisch leitfähigen Schicht wird die Schicht vorteilhafterweise durch eine oder mehrere weitere Trennlinien unterteilt. Es ist besonders vorteilhaft, wenn die zweite elektrisch leitfähige Struktur die erste elektrisch leitfähige Struktur zumindest teilweise und bevorzugt vollständig umrandet. Eine derartige Umrandung ist vorteilhaft, da dadurch der Einfluss des Heizbereichs und besonders eine Spannungsänderung im Heizbereich, auf die Schaltfläche verringert wird.

In einer weiteren vorteilhaften Ausgestaltung der erfindungsgemäßen Scheibe weist der Umgebungsbereich eine ähnliche oder dieselbe Form wie der Schaltbereich auf. Insbesondere sind kreisförmige, elliptische oder tropfenförmige Formen oder Formen mit abgerundeten Ecken sowie Streifenformen besonders vorteilhaft, da dadurch der Heizstrom besonders vorteilhaft um den Umgebungsbereich herum geleitet wird und keine oder nur geringe lokale Überhitzungen, sogenannte Hotspots, auftreten.

Besonders vorteilhaft ist es, wenn die zweite elektrisch leitfähige Struktur einen weiteren Anschlussbereich aufweist, der mit der Sensorelektronik verbindbar ist. In einer solchen Anordnung bilden die erste und zweite elektrisch leitfähige Struktur zwei Elektroden aus, die kapazitiv miteinander gekoppelt sind. Die Kapazität des von den Elektroden gebildeten Kondensators ändert sich bei Annäherung eines Körpers, beispielsweise eines menschlichen Körperteils. Die Kapazitätsänderung wird durch eine Sensorelektronik gemessen und bei Überschreiten eines Schwellwerts wird ein Schaltsignal ausgelöst. Der sensitive Bereich wird durch Form und Größe des Bereichs, in denen die Elektroden kapazitiv gekoppelt sind, festgelegt.

Alternativ kann die Schaltfläche auch induktive, thermische oder sämtliche andere Sensorfunktionen aufweisen, die berührungslos sind. Berührungslos bedeutet dabei, dass keine direkte Berührung der elektrisch leitfähigen Struktur zum Auslösen eines Schaltvorgangs notwendig ist. Es versteht sich, dass die Schaltfunktion auch bei direkter Berührung der elektrisch leitfähigen Struktur wirksam ist, falls die elektrisch leitfähige Struktur für den Benutzer zugänglich ist. Prinzipiell können auch Schaltflächen mit berührungsabhängigen Sensorfunktionen ausgebildet sein.

In einer vorteilhaften Ausgestaltung der erfindungsgemäßen Scheibe kann die elektrisch leitfähige Struktur, die die Schaltfläche ausbildet, drei funktionell unterschiedliche Bereiche aufweisen: einen Berührungsbereich, einen Anschlussbereich, der eine elektrische Leitungsverbindung aufweist, mit der die elektrisch leitfähige Struktur nach außen elektrisch leitend verbunden ist, und einen Zuleitungsbereich, der den Berührungsbereich mit dem Anschlussbereich elektrisch leitend verbindet. Der Berührungsbereich ist bevorzugt größer ausgebildet als der Zuleitungsbereich. Eine mit der elektrisch leitfähigen Struktur verbundene Sensorelektronik kann beispielsweise in ihrer Empfindlichkeit derart gewählt werden, dass nur bei einer Berührung einer der Scheibenoberflächen im Bereich des Berührungsbereichs durch einen Menschen ein Schaltsignal ausgegeben wird, eine Berührung der Scheibenoberflächen über dem Zuleitungsbereich hingegen kein Schaltsignal auslöst. Dies kann alternativ oder zusätzlich durch eine geeignete Wahl der Geometrien von Berührungsbereich und Zuleitungsbereich optimiert werden. Beispielsweise kann der Zuleitungsbereich eine geringe Breite und eine große Länge aufweisen, wohingegen der Berührungsbereich bevorzugt annähernd quadratisch, rund, kreisförmig, oder tropfenförmig ausgebildet ist und damit eine große berührbare Fläche, beispielsweise für einen oder mehrere menschliche Finger oder eine Handfläche, aufweist.

Die Schaltfläche ist in die erfindungsgemäße Scheibe integriert. Es ist also kein Schalter als separates Bauteil nötig, welches an der Scheibe angebracht werden muss. Die erfindungsgemäße Scheibe, welche als Einzelscheibe oder als Verbundscheibe ausgebildet sein kann, weist bevorzugt auch keine sonstigen Bauteile auf, die im Durchsichtbereich auf ihren Oberflächen angeordnet sind. Das ist besonders vorteilhaft im Hinblick auf eine dünne Bauweise der Scheibe sowie einer nur geringen Störung der Durchsicht durch die Scheibe.

Ein vorteilhafter Aspekt der Erfindung umfasst eine Scheibenanordnung mit einer erfindungsgemäßen Scheibe und einer Sensorelektronik, die über den Anschlussbereich mit der Schaltfläche und gegebenenfalls über einen weiteren Anschlussbereich mit der Umgebungsfläche elektrisch verbunden ist. Die Sensorelektronik ist bevorzugt eine kapazitive Sensorelektronik.

Die erfindungsgemäße Scheibe umfasst ein Beleuchtungsmittel, mit dem die Schaltfläche markierbar ist. Dies ist insbesondere bei transparenten, nicht oder kaum sichtbaren Schaltflächen besonders vorteilhaft, da dies es ermöglicht, die Schaltfläche sicher zu berühren und den Schaltvorgang sicher auszulösen. Die Beleuchtung ist insbesondere bei Nacht oder Dunkelheit vorteilhaft, da sie ein schnelles Auffinden der Schaltfläche ermöglicht. Insbesondere bei einer Verwendung der erfindungsgemäßen Scheibe als Fahrzeugscheibe ist es dem Fahrer sehr einfach möglich, die Schaltfläche aufzufinden und zu berühren, ohne vom Verkehrsgeschehen zu lange abgelenkt zu sein.

Unter Beleuchtungsmittel sei dabei eine Lichtquelle oder ein Lichtablenkmittel verstanden, das in der Umgebung der Schaltfläche oder eines Teilbereichs der Schaltfläche wie einem Berührungsbereich angeordnet ist und diese markiert. Das Lichtablenkmittel kann dabei durch eine Lichtquelle, die entfernt vom Lichtablenkmittel in oder an der Scheibe angeordnet ist, beleuchtet werden. Zur Verstärkung des Effekts können Lichtquelle und Lichtablenkmittel auch an derselben Stelle oder in unmittelbarer Nachbarschaft angeordnet werden.

Erfindungsgemäß umfasst das Beleuchtungsmittel eine Lichtquelle, bevorzugt eine Leuchtdiode (LED), eine organische Leuchtdiode (OLED), eine Glühbirne oder andere aktive Leuchtkörper, wie ein lumineszentes Material, bevorzugt ein fluoreszierendes oder phosphoreszierendes Material.

Insbesondere ist die Lichtquelle in der unmittelbaren Umgebung der Schaltfläche derart angeordnet, dass die Schaltfläche dadurch für den Benutzer erkennbar wird. Unmittelbare Umgebung bedeutet hier bevorzugt mit einem Abstand von bis zu 10 cm, besonders bevorzugt von 0 cm bis 3 cm.

Erfindungsgemäß ist die Lichtquelle an der Seitenkante des Substrats und/oder der Seitenkante der Deckscheibe, oder in einer Öffnung des Substrats oder der Deckscheibe angeordnet.

Derartig angeordnete Beleuchtungsmittel in Form einer Lichtquelle haben den besonderen Vorteil besonders lichtstark zu sein.

Die Lichtquelle kann in diesen Fällen durch dünne Drähte, insbesondere durch dünne metallische Drähte mit elektrisch isolierender Ummantelung, elektrisch kontaktiert werden. Alternativ kann die Leuchtquelle über aufgedruckte Strukturen aus einem elektrisch leitfähigen Material, wie einer Silberdruckpaste, elektrisch kontaktiert werden.

In einer weiteren Alternative kann die Lichtquelle durch Bereiche einer elektrisch leitfähigen Schicht elektrisch kontaktiert werden, wobei die Bereiche bevorzugt durch Trennlinien von der umgebenden elektrisch leitfähigen Schicht abgetrennt sind. Die elektrisch leitfähige Schicht kann dabei auch ein Teil der elektrisch leitfähigen Struktur des Schaltbereichs oder ein Teil des Heizbereichs sein.

Erfindungsgemäß ist das Beleuchtungsmittel als Lichtablenkmittel ausgebildet, das durch eine entfernt angeordnete Lichtquelle in, an oder außerhalb der Scheibe beleuchtet wird.

Das Beleuchtungsmittel markiert die Position der Schaltfläche durch eine leuchtende oder beleuchtbare Fläche relativ zur Schaltfläche. Das Beleuchtungsmittel und die Schaltfläche können in räumlich unterschiedlichen Ebenen angeordnet sein. Mit Ebene wird hierbei eine Fläche bezeichnet, die parallel zur Oberfläche der Scheibe ausgeformt ist. Das Beleuchtungsmittel ist erfindungsgemäß so angeordnet, dass die Fläche, die aus der Projektion des Beleuchtungsmittel auf die Ebene der Schaltfläche hervorgeht, innerhalb der Schaltfläche angeordnet ist und/oder die Schaltfläche fortlaufend oder unterbrochen umrandet. Hierbei wird eine orthogonale Projektion des Beleuchtungsmittels durchgeführt, wobei die Projektionsebene diejenige Ebene ist, in der die Schaltfläche angeordnet ist. Die Projektionsebene kann auch von einer gekrümmten Fläche aufgespannt werden, insbesondere im Falle einer gekrümmten erfindungsgemäßen Scheibe.

Der Flächeninhalt der Fläche, die aus einer Projektion des Lichtablenkmittels auf die Ebene der Schaltfläche hervorgeht, beträgt bevorzugt von 5 % bis 300 %, besonders bevorzugt von 10 % bis 200 % und ganz besonders bevorzugt von 20 % bis 150 % des Flächeninhalts der Schaltfläche. Das ist besonders vorteilhaft im Hinblick auf eine deutliche und eindeutige Kennzeichnung der Position der Schaltfläche auf der erfindungsgemäßen Scheibe durch am Lichtablenkmittel gestreutes Licht.

Die Fläche, die aus der Projektion des Beleuchtungsmittels auf die Ebene der Schaltfläche hervorgeht, kann vollständig innerhalb der Schaltfläche angeordnet sein. Der Flächeninhalt der Fläche, die aus der Projektion des Beleuchtungsmittels auf die Ebene der Schaltfläche hervorgeht, ist dabei bevorzugt kleiner als der Flächeninhalt der Schaltfläche. Dadurch wird die Position der Schaltfläche durch die leuchtende Fläche auf der Scheibe vorteilhaft markiert, wobei auch eine Berührung der Scheibe in einem an die leuchtende Fläche grenzenden Bereich noch zum Auslösen eines Schaltvorgangs führt.

Alternativ kann der Flächeninhalt der Fläche, die aus der Projektion des Beleuchtungsmittels auf die Ebene der Schaltfläche hervorgeht, gleich dem Flächeninhalt der Schaltfläche sein. Die Fläche, die aus der Projektion des Beleuchtungsmittels auf die Ebene der Schaltfläche hervorgeht, und die Schaltfläche sind dabei bevorzugt identisch oder annähernd identisch. Dadurch wird die Position der Schaltfläche durch die leuchtende Fläche auf der Scheibe vorteilhaft gekennzeichnet. Eine Berührung der leuchtenden Fläche auf der Scheibe führt zum Auslösen eines Schaltvorgangs.

In einer alternativen vorteilhaften Ausgestaltung der Erfindung ist der Flächeninhalt der Fläche, die aus der Projektion des Beleuchtungsmittels auf die Ebene der Schaltfläche hervorgeht, größer als der Flächeninhalt der Schaltfläche. Ein erster Bereich der Fläche, die aus der Projektion des Beleuchtungsmittels auf die Ebene der Schaltfläche hervorgeht, überlappt dabei bevorzugt vollständig mit der Schaltfläche. Ein zweiter Bereich der Fläche, die aus der Projektion des Beleuchtungsmittels auf die Ebene der Schaltfläche hervorgeht, umrandet die Schaltfläche. Da ein Benutzer zum Auslösen eines Schaltvorgangs intuitiv den inneren Bereich der leuchtenden Fläche auf der Scheibe berührt, wird die Position der Schaltfläche vorteilhaft markiert.

In einer alternativen vorteilhaften Ausgestaltung der Erfindung wird die Schaltfläche von der Fläche, die aus der Projektion des Beleuchtungsmittels auf die Ebene der Schaltfläche hervorgeht, umrandet. Die Umrandung kann fortlaufend oder unterbrochen ausgestaltet sein und beispielsweise eine Breite von 0,2 cm bis 2 cm, etwa 1 cm, aufweisen. Die Fläche, die aus der Projektion des Beleuchtungsmittels auf die Ebene der Schaltfläche hervorgeht, und die Schaltfläche überlappen einander nicht oder nur im Randbereich der Schaltfläche. Da ein Benutzer zum Auslösen eines Schaltvorgangs intuitiv den von der leuchtenden Fläche umrandeten Bereich auf der Scheibe berührt, wird die Position der Schaltfläche vorteilhaft markiert.

In einer alternativen vorteilhaften Ausgestaltung umfasst das Beleuchtungsmittel einen ersten und einen zweiten Bereich, die nicht miteinander verbunden sind. Die Fläche, die aus der Projektion des ersten Bereichs des Beleuchtungsmittels auf die Ebene der Schaltfläche hervorgeht, umrandet die Schaltfläche fortlaufend oder unterbrochen. Die Fläche, die aus der Projektion des zweiten Bereichs des Beleuchtungsmittels auf die Ebene der Schaltfläche hervorgeht, ist vollständig innerhalb der Schaltfläche angeordnet. Der erste Bereich des Beleuchtungsmittels kann beispielsweise als umlaufender Kreisrand ausgeformt sein. Der zweite Bereich des Lichtablenkmittels kann beispielsweise als Symbol oder Piktogramm ausgeformt sein. Dadurch wird die Position der Schaltfläche durch die leuchtende Fläche auf der Scheibe vorteilhaft markiert.

In einer vorteilhaften Ausgestaltung der erfindungsgemäßen Scheibe wird das Licht der Lichtquelle über die Seitenkante des Substrats in die erfindungsgemäße Scheibe eingekoppelt. Das Licht der Lichtquelle tritt also über die Seitenkante des Substrats in die erfindungsgemäße Scheibe ein. Ein Bereich der Scheibe wird vom eingekoppelten Licht bestrahlt. Der vom Licht bestrahlte Bereich der Scheibe wird dabei durch die Abstrahlcharakteristik des Lichteinstrahlmittels bestimmt. Das Substrat weist typischerweise einen höheren Brechungsindex als die Umgebung der Scheibe auf. Das eingekoppelte Licht wird an den Oberflächen des Substrats nach dem Prinzip der Totalreflexion in das Innere des Substrats zurückgeworfen. Alternativ wird das eingekoppelte Licht an den vom Substrat abgewandten Oberflächen weiterer mit dem Substrat verbundener Schichten, die einen ähnlichen Brechungsindex wie das Substrat aufweisen, totalreflektiert und in das Innere der Scheibe zurückgeworfen. Licht, welches beim Durchlaufen der Scheibe auf das Lichtablenkmittel trifft, wird nicht totalreflektiert, sondern verlässt die Scheibe, bevorzugt durch Streuung am Lichtablenkmittel. Der Bereich des Lichtablenkmittels wird daher von einem Betrachter als leuchtende Fläche auf der Scheibe wahrgenommen.

Es versteht sich, dass die Lichtquelle gleichermaßen Licht in die Seitenkante der Deckscheibe oder der Zwischenschicht einkoppeln kann und ein entsprechend angeordnetes Lichtablenkmittel dieses Licht wieder auskoppeln kann.

Das Lichtablenkmittel umfasst mindestens eine Struktur zur Lichtstreuung. Diese Struktur umfasst besonders bevorzugt Partikel, Punktraster, Aufkleber, Anlagerungen, Einkerbungen, Einritzungen, Strichraster, Aufdrucke und/oder Siebdrucke. Das Lichtablenkmittel kann eine einzige zusammenhängende Fläche ausbilden. Alternativ kann das Lichtablenkmittel zwei oder mehrere voneinander getrennte Flächen ausbilden.

Das Lichtablenkmittel kann jede beliebige Form aufweisen, die dazu geeignet ist, die Position der Schaltfläche zu markieren. Das Lichtablenkmittel kann beispielsweise eine einfache zweidimensionale geometrische Form wie einen Kreis, eine Ellipse, ein Dreieck, ein Rechteck, ein Quadrat oder ein anders geartetes Viereck, ein höheres Polygon oder Kombinationen davon aufweisen. Die geometrische Figur kann dabei vollflächig mit dem Lichtablenkmittel ausgefüllt sein. Alternativ kann das Lichtablenkmittel entlang des Randes der geometrischen Figur umlaufend oder unterbrochen angeordnet sein. Das Lichtablenkmittel kann auch eine Form aufweisen, welche die über die Schaltfläche gesteuerte Funktion beschreibt, beispielsweise ein "Plus"- oder "Minus"-Zeichen, ein oder mehrere Buchstaben und/oder Zahlen oder ein Piktogramm. Das Lichtablenkmittel kann auch die Form eines anderen graphischen Symbols, beispielsweise eines Firmen- oder Markensymbols aufweisen. Das Lichtablenkmittel kann auch eine Form aufweisen, die sich aus einer Kombination der genannten Beispiele ergibt, beispielsweise einen umlaufenden Kreisrand um ein Piktogramm.

In einer vorteilhaften Ausgestaltung der Erfindung ist das Substrat ein Einscheiben-Sicherheitsglas. Die elektrisch leitfähige Struktur kann an der gleichen Oberfläche des Substrats wie das Beleuchtungsmittel und insbesondere ein Lichtablenkmittel angeordnet sein. Dabei kann die elektrisch leitfähige Struktur aus der Richtung des Substrats über oder unter dem Lichtablenkmittel oder in der gleichen Ebene wie das Lichtablenkmittel angeordnet sein. Alternativ können die elektrisch leitfähige Struktur und das Lichtablenkmittel an den gegenüberliegenden Oberflächen des Substrats angeordnet sein.

Zwischen Substrat und elektrisch leitfähiger Struktur, zwischen Substrat und Beleuchtungsmittel und/oder zwischen elektrisch leitfähiger Struktur und Beleuchtungsmittel können weitere Schichten angeordnet sein. Auf der vom Substrat abgewandten Seite von elektrisch leitfähiger Struktur oder Beleuchtungsmittel können weitere Schichten angeordnet sein, beispielsweise zum Schutz gegen Beschädigung. Die elektrisch leitfähige Struktur und/oder das Beleuchtungsmittel können auch auf einer mit dem Substrat verbundenen Trägerfolie aufgebracht sein.

Die transparente, elektrisch leitfähige Schicht, die elektrisch leitfähige Struktur, die Lichtquelle und/oder das Lichtablenkmittel können auf einer Trägerfolie aufgebracht sein. Die Trägerfolie enthält bevorzugt zumindest ein Polyester und/oder ein Polyimid, besonders bevorzugt ein thermoplastisches Polyester, beispielsweise Polyethylennaphthalat (PEN) oder Polyethylenterephthalat (PET). Das ist besonders vorteilhaft im Hinblick auf die Stabilität und Verarbeitbarkeit der Trägerfolie. In einer besonders bevorzugten Ausgestaltung sind die elektrisch leitfähige Struktur und das Lichtablenkmittel auf der Trägerfolie aufgebracht. Der besondere Vorteil liegt in einer einfachen gemeinsamen Positionierung von elektrisch leitfähiger Struktur und Lichtablenkmittel bei der Herstellung des Verbund-Sicherheitsglases. Die Trägerfolie ist zwischen Substrat und Deckscheibe angeordnet. Die Trägerfolie mit der transparenten, elektrisch leitfähigen Schicht, der elektrisch leitfähigen Struktur, der Lichtquelle und/oder dem Lichtablenkmittel ist besonders bevorzugt über zumindest eine erste Zwischenschicht mit dem Substrat und über zumindest eine zweite Zwischenschicht mit der Deckscheibe verbunden. Die Dicke der Trägerfolie beträgt bevorzugt von 10 µm bis 1 mm, besonders bevorzugt von 30 µm bis 200 µm. In diesem Bereich der Dicke ist die Trägerfolie vorteilhaft stabil und gut zu verarbeiten. Die Länge und Breite der Trägerfolie kann gleich der Länge und Breite des Substrats sein. Die Länge und Breite der Trägerfolie kann auch kleiner als die Länge und Breite des Substrats sein.

Die erfindungsgemäße Scheibe weist bevorzugt einen transparenten Durchsichtbereich auf. Das bedeutet, dass ein Betrachter Objekte durch den Durchsichtbereich der Scheibe hindurch wahrnehmen kann. Die Schaltfläche sowie das Beleuchtungsmittel sind bevorzugt im Durchsichtbereich der Scheibe angeordnet. Im Durchsichtbereich sind bevorzugt keine großflächigen opaken Bauteile angeordnet. Der Flachleiter ist bevorzugt vollständig außerhalb des Durchsichtbereichs der Scheibe angeordnet. Dadurch wird die Durchsicht durch die Scheibe nicht durch den Flachleiter gestört.

Die Kontaktierung der Sammelleiter, der Lichtquelle und/oder der elektrisch leitfähigen Struktur der Schaltfläche erfolgt bevorzugt über Flachleiter. Der elektrisch leitfähige Kern des Flachleiters besteht bevorzugt aus einem Band eines Metalls oder einer Legierung, beispielsweise aus Kupfer, verzinntem Kupfer, Aluminium, Gold, Silber und/oder Zinn. Das Band weist bevorzugt eine Dicke von 0,3 mm bis 0,2 mm, beispielsweise 0,1 mm, und eine Breite von 2 mm bis 16 mm auf. Die isolierende Ummantelung enthält bevorzugt Kunststoff und besteht beispielsweise auf einer Kunststoff-Folie mit einer Dicke von 0,025 mm bis 0,05 mm.

Die elektrisch leitfähige Struktur ist bevorzugt mit dem Flachleiter elektrisch verbunden. Über den Flachleiter wird die elektrisch leitfähige Struktur bevorzugt zumindest mit einer externen Sensor- oder Steuerungselektronik verbunden. Die Sensorelektronik ist auf den jeweiligen Einsatzzweck abgestimmt und kann beim Auslösen eines Schaltvorgangs beispielsweise einen Mechanismus zum Öffnen oder Schließen einer Tür oder die Beheizung der Scheibe auslösen.

Die elektrische Verbindung zwischen Flachleiter und jeder durch die elektrisch leitfähige Struktur gebildeten Elektroden erfolgt erfindungsgemäß über einen Anschlussbereich als elektrisches Verbindungselement. Der Flachleiter ist über eine elektrische Leitungsverbindung mit dem Anschlussbereich der Schaltfläche verbunden, bevorzugt durch Löten, Klemmen oder mittels eines elektrisch leitfähigen Klebstoffs. Dadurch können auf einfache Weise und für den Benutzer kaum sichtbar die Kontakte aus der Scheibe heraus oder von der Scheibe weg geführt werden. Der Flachleiter ist bevorzugt im Randbereich der Scheibe mit dem Anschlussbereich verbunden und kann beispielsweise durch einen Rahmen, sonstige Befestigungselemente oder durch einen Abdecksiebdruck abgedeckt sein. Der Randbereich der Scheibe, in dem der Flachleiter mit dem Anschlussbereich elektrisch leitend verbunden ist, weist bevorzugt eine Breite von kleiner oder gleich 10 cm auf, besonders bevorzugt von kleiner oder gleich 5 cm. Der Flachleiter verläuft vom Randbereich der Scheibe über die Seitenkante der Scheibe hinaus von der Scheibe weg, um mit einer Sensorelektronik verbunden zu werden. Der Flachleiter überlappt die Oberfläche des Substrats also entlang einer Länge von bevorzugt höchstens 10 cm, besonders bevorzugt höchstens 5 cm, beispielsweise von 1 cm bis 5 cm oder von 2 cm bis 3 cm. Dadurch wird die Durchsicht durch die Scheibe vorteilhaft wenig durch den Flachleiter gestört. Es versteht sich, dass eine Lichtquelle auf ähnliche Weise mit beispielsweise einem Flachleiter verbunden werden kann und dadurch beispielsweise mit einer externen Spannungsversorgung oder Steuerungselektronik verbunden werden kann.

Bildet die elektrisch leitfähige Struktur zwei miteinander gekoppelte Elektroden aus, so weist jede Elektrode einen Anschlussbereich auf, der mit einem Flachleiter kontaktiert werden kann. Der Flachleiter umfasst in diesem Fall bevorzugt zwei voneinander getrennte elektrisch leitfähige Kerne, die in einer gemeinsamen elektrisch isolierenden Ummantelung eingefasst sind. Die beiden elektrischen Verbindungselemente werden mit jeweils einem elektrisch leitfähigen Kern des Flachleiters verbunden. Alternativ können zwei Flachleiter zur Kontaktierung der beiden elektrischen Verbindungselemente verwendet werden.

Ein weiterer Aspekt der Erfindung betrifft eine Scheibenanordnung umfassend:
- eine erfindungsgemäße Scheibe mit beleuchteter Schaltfläche und Heizfunktion,
- mindestens eine Sensorelektronik sowie mindestens eine Spannungsquelle, die mit der Schaltfläche, dem Heizbereich und dem Beleuchtungsmittel verbunden ist,
wobei die Sensorelektronik derart ausgebildet ist, dass über eine Berührung der Schalt-fläche durch einen Menschen ein Schaltsignal zur Steuerung der Heizfunktion ausgegeben wird. Dabei ist es besonders vorteilhaft, wenn die Beleuchtung des Schaltbereichs den Schaltzustand der Heizfunktion, beispielsweise Heizfunktion "Ein" oder "Aus", anzeigt. Dies kann beispielsweise durch einen Wechsel der Farbe des Beleuchtungsmittels (beispielsweise durch einen Wechsel der Farbe der Lichtquelle) oder über einen Wechsel der Position des beleuchteten Beleuchtungsmittels erfolgen.

Die Erfindung umfasst weiter ein Verfahren zur Herstellung einer erfindungsgemäßen Scheibe mit beleuchteter Schaltfläche und Heizfunktion, mindestens umfassend:
Aufbringen einer elektrisch leitfähigen Schicht auf eine Oberfläche (III) eines transparenten Substrats,
- Einbringen mindestens einer Trennlinie, die die Schicht in mindestens einen Heizbereich und eine Schaltfläche elektrisch unterteilt,
- Aufbringen von mindestens zwei zum Anschluss an eine Spannungsquelle vorgesehene Sammelleiter, die mit der Schicht so verbunden werden, dass zwischen den Sammelleitern ein Strompfad für einen Heizstrom geformt wird, und
- Anordnen eines Beleuchtungsmittels, mit dem die Schaltfläche zumindest abschnittsweise markierbar ist.

Es versteht sich, dass die Verfahrensschritte in jeder geeigneten Reihenfolge erfolgen können, wobei die elektrische leitfähige Schicht auf das Substrat aufgebracht wird und in einem der folgenden Schritte die Trennlinien in die elektrisch leitfähige Schicht eingebracht werden.

Das Aufbringen der elektrisch leitfähigen Schicht kann durch an sich bekannte Verfahren erfolgen, bevorzugt durch magnetfeldunterstützte Kathodenzerstäubung. Das ist besonders vorteilhaft im Hinblick auf eine einfache, schnelle, kostengünstige und gleichmäßige Beschichtung des Substrats. Die elektrisch leitfähige Schicht kann aber auch beispiels-weise durch Aufdampfen, chemische Gasphasenabscheidung (chemical vapour deposition, CVD), plasmagestützte Gasphasenabscheidung (PECVD) oder durch nasschemische Verfahren aufgebracht werden.

Das Substrat kann nach dem Aufbringen der elektrisch leitfähigen Schicht einer Temperaturbehandlung unterzogen werden. Dabei wird das Substrat mit der elektrisch leitfähigen Schicht auf eine Temperatur von mindestens 200°C, bevorzugt mindestens 300°C erwärmt. Die Temperaturbehandlung kann der Erhöhung der Transmission und/oder der Verringerung des Flächenwiderstands der elektrisch leitfähigen Schicht dienen.

Das Substrat kann nach dem Aufbringen der elektrisch leitfähigen Schicht gebogen werden, typischerweise bei einer Temperatur von 500 °C bis 700 °C. Da es technisch einfacher ist, eine plane Scheibe zu beschichten, ist dieses Vorgehen vorteilhaft, wenn das Substrat gebogen werden soll. Alternativ kann das Substrat aber auch vor dem Aufbringen der elektrisch leitfähigen Schicht gebogen werden, beispielsweise wenn die elektrisch leitfähige Schicht nicht dazu geeignet ist, einen Biegeprozess ohne Beschädigungen zu überstehen.

Das Aufbringen des Sammelleiters erfolgt bevorzugt durch Aufdrucken und Einbrennen einer elektrisch leitfähigen Paste in einem Siebdruckverfahren oder in einem Inkjet-Verfahren. Alternativ kann der Sammelleiter als Streifen einer elektrisch leitfähigen Folie auf die elektrisch leitfähigen Schicht aufgebracht, bevorzugt aufgelegt, angelötet oder angeklebt werden.

Bei Siebdruckverfahren erfolgt die laterale Formgebung durch die Maskierung des Gewebes, durch das die Druckpaste mit den Metallpartikeln gedrückt wird. Durch eine geeignete Formgebung der Maskierung kann beispielsweise die Breite b des Sammelleiters besonders einfach vorgeben und variiert werden.

Die Entschichtung einzelner Trennlinien in der elektrisch leitfähigen Schicht erfolgt vorzugsweise durch einen Laserstrahl. Verfahren zum Strukturieren dünner Metallfilme sind beispielsweise aus EP 2 200 097 A1 oder EP 2 139 049 A1 bekannt. Die Breite der Entschichtung beträgt bevorzugt 10 µm bis 1000 µm, besonders bevorzugt 30 µm bis 200 µm und insbesondere 70 µm bis 140 µm. In diesem Bereich findet eine besonders saubere und rückstandsfreie Entschichtung durch den Laserstrahl statt. Die Entschichtung mittels Laserstrahl ist besonders vorteilhaft, da die entschichteten Linien optisch sehr unauffällig sind und das Erscheinungsbild und die Durchsicht nur wenig beeinträchtigen. Die Entschichtung einer Linie mit einer Breite, die breiter ist als die Breite eines Laserschnitts, erfolgt durch mehrmaliges Abfahren der Linie mit dem Laserstrahl. Die Prozessdauer und die Prozesskosten steigen deshalb mit zunehmender Linienbreite an. Alternativ kann die Entschichtung durch mechanisches Abtragen sowie durch chemisches oder physikalisches Ätzen erfolgen.

Eine vorteilhafte Weiterbildung des erfindungsgemäßen Verfahrens umfasst mindestens die folgenden weiteren Schritte:
- Anordnen einer thermoplastischen Zwischenschicht auf der beschichteten Oberfläche des Substrats und Anordnen einer Deckscheibe auf der thermoplastischen Zwischenschicht und Verbinden des Substrats mit der Deckscheibe über die thermoplastische Zwischenschicht.

Dabei wird das Substrat so angeordnet, dass diejenige ihrer Oberflächen, welche mit der elektrisch leitfähigen Schicht versehen ist, der thermoplastischen Zwischenschicht zugewandt ist. Die Oberfläche wird dadurch zur innenseitigen Oberfläche des Substrats.

Die thermoplastische Zwischenschicht kann durch eine einzelne oder auch durch zwei oder mehrere thermoplastische Folien, die flächenmäßig übereinander angeordnet werden, ausgebildet werden.

Das Verbinden von Substrat und Deckscheibe erfolgt bevorzugt unter Einwirkung von Hitze, Vakuum und/oder Druck. Es können an sich bekannte Verfahren zur Herstellung einer Scheibe verwendet werden.

Es können beispielsweise sogenannte Autoklavverfahren bei einem erhöhten Druck von etwa 10 bar bis 15 bar und Temperaturen von 130 °C bis 145 °C über etwa 2 Stunden durchgeführt werden. An sich bekannte Vakuumsack- oder Vakuumringverfahren arbeiten beispielsweise bei etwa 200 mbar und 80 °C bis 110 °C. Die erste Scheibe, die thermo-plastische Zwischenschicht und die zweite Scheibe können auch in einem Kalander zwischen mindestens einem Walzenpaar zu einer Scheibe verpresst werden. Anlagen dieser Art sind zur Herstellung von Scheiben bekannt und verfügen normalerweise über mindestens einen Heiztunnel vor einem Presswerk. Die Temperatur während des Pressvorgangs beträgt beispielsweise von 40 °C bis 150 °C. Kombinationen von Kalander- und Autoklavverfahren haben sich in der Praxis besonders bewährt. Alternativ können Vakuum-Iaminatoren eingesetzt werden. Diese bestehen aus einer oder mehreren beheizbaren und evakuierbaren Kammern, in denen die erste Scheibe und die zweite Scheibe innerhalb von beispielsweise etwa 60 Minuten bei verminderten Drücken von 0,01 mbar bis 800 mbar und Temperaturen von 80 °C bis 170 °C laminiert werden.

Bei einer vorteilhaften Ausgestaltung des erfindungsgemäßen Verfahrens ist die Positionierung der elektrisch leitfähigen Struktur und des Beleuchtungsmittels so zu wählen, dass die Fläche, die aus der Projektion des Beleuchtungsmittel auf die Ebene der Schaltfläche hervorgeht, innerhalb der Schaltfläche angeordnet ist und/oder die Schaltfläche fortlaufend oder unterbrochen umrandet. Bei einer Beleuchtung des Lichtablenkmittels durch eine Lichtquelle an der Seitenkante des Substrats sind die Leuchtquelle und das Lichtablenkmittel so zu positionieren, dass der vom Licht der Lichtquelle bestrahlte Bereich der Scheibe das Lichtablenkmittel umfasst.

Die Erfindung umfasst außerdem die Verwendung der Scheibe mit beleuchteter Schaltfläche als funktionales und/oder dekoratives Einzelstück und/oder als Einbauteil in Möbeln und Geräten, insbesondere elektronischen Geräten mit Kühl- oder Heizfunktion, zur Verglasung von Gebäuden, insbesondere im Zugangs- oder Fensterbereich, oder zur Verglasung in einem Fahrzeug für den Verkehr auf dem Lande, in der Luft oder zu Wasser, insbesondere in Kraftfahrzeugen, Bussen, Straßenbahnen, U-Bahnen und Zügen zur Personenbeförderung und für den öffentlichen Nah- und Fernverkehr, beispielsweise als Fahrzeugtür oder in einer Fahrzeugtür.

Die erfindungsgemäße Scheibe ist besonders vorteilhaft für eine Verwendung als Windschutzscheibe eines Personenkraftwagens oder Lastkraftwagen geeignet. Der Fahrer oder Beifahrer kann auch bei Dunkelheit die beleuchtete Schaltfläche auf der Scheibe erkennen und durch einfache und bequeme Berührung von der Sitzposition aus Schaltvorgänge auslösen. Durch den Schaltvorgang lässt sich bevorzugt die Heizfunktion der Scheibe selbst ein- oder ausschalten. Dabei kann bevorzugt das Beleuchtungsmittel den Schaltzustand der Heizfunktion visualisieren, beispielsweise durch Ein- oder Ausschalten der Beleuchtung oder durch Ändern der Farbe der Beleuchtung oder durch Änderung der Position der Beleuchtung des Beleuchtungsmittels.

Die Erfindung wird anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein.

Es zeigen:
- Figur 1A: eine Draufsicht auf eine Ausgestaltung einer erfindungsgemäßen Scheibenanordnung mit einer erfindungsgemäßen Scheibe,
- Figur 1B: eine vergrößerte Darstellung des Ausschnitts Z aus Figur 1A in der Ebene der Schaltfläche,
- Figur 1C: eine vergrößerte Darstellung des Ausschnitts Z aus Figur 1A in der Ebene der Lichtablenkmittel,
- Figur 1D: eine Querschnittsdarstellung entlang der Schnittlinie A-A' aus Figur 1A,
- Figur 2A: eine alternative Ausgestaltung einer erfindungsgemäßen Scheibe in einer vergrößerten Darstellung des Ausschnitts Z aus Figur 1A,
- Figur 2B: eine Querschnittsdarstellung entlang der Schnittlinie B-B' aus Figur 2A,
- Figur 3A: eine Draufsicht auf eine alternative Ausgestaltung der erfindungsgemäßen Scheibe,
- Figur 3B: eine vergrößerte Darstellung des Ausschnitts Z aus Figur 3A,
- Figur 3C: eine Querschnittsdarstellung entlang der Schnittlinie C-C' aus Figur 3A,
- Figur 4: ein detailliertes Flussdiagramm einer Ausführungsform des erfindungsgemäßen Verfahrens.

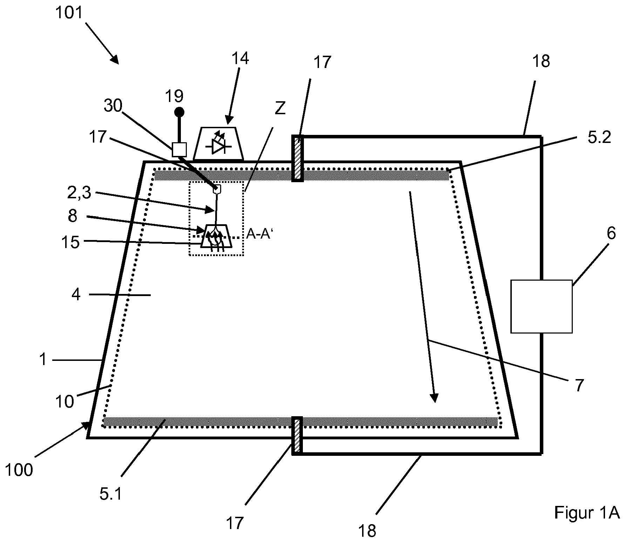

Figur 1A zeigt eine Draufsicht auf eine beispielhafte Ausgestaltung einer erfindungs-gemäßen Scheibenanordnung 101 mit einer erfindungsgemäßen Scheibe 100. Die Scheibe 100 umfasst ein Substrat 1 und besteht beispielsweise aus Natron-Kalkglas. Auf einer der Oberfläche III des Substrats 1 ist eine elektrische leitfähige Schicht 10 aufgebracht. Die elektrische leitfähige Schicht 10 ist ein Schichtensystem, welches beispielsweise drei elektrisch leitfähige Silberschichten enthält, die durch dielektrische Schichten voneinander getrennt sind. Fließt ein Strom durch die elektrische leitfähige Schicht 10, so wird sie infolge ihres elektrischen Widerstands und joulscher Wärmeentwicklung erwärmt. Die elektrische leitfähige Schicht 10 kann daher für eine aktive Beheizung der Scheibe 100 verwendet werden. Die Abmessungen der Scheibe 100 betragen beispielsweise 0,9 m x 1,5 m.

Die elektrische leitfähige Schicht 10 ist durch eine Trennlinie 11 in einen Heizbereich 4 und eine elektrisch leitfähige Struktur 2, die eine Schaltfläche 3 ausbildet, unterteilt. Das heißt sowohl der Heizbereich 4 als auch die Schaltfläche 3 bestehen aus der elektrisch leitfähigen Schicht 10, sind aber voneinander durch die Trennlinie 11 elektrisch isoliert. Die Trennlinie 11 hat lediglich eine Breite d₁ von beispielsweise 100 µm und ist beispielsweise durch Laserstrukturierung in die elektrisch leitfähige Schicht 10 eingebracht. Trennlinien 11 mit einer derart geringen Breite sind optisch kaum wahrnehmbar und stören die Durchsicht durch die Scheibe 100 nur wenig, was besonders für eine Verwendung in Fahrzeugen von besonderer Wichtigkeit für die Fahrsicherheit ist.

Zur elektrischen Kontaktierung des Heizbereichs 4 ist jeweils ein erster Sammelleiter 5.1 im unteren Randbereich und ein weiterer, zweiter Sammelleiter 5.2 im oberen Randbereich des Heizbereichs 4 angeordnet. Die Sammelleiter 5.1, 5.2 enthalten beispielsweise Silberpartikel und wurden im Siebdruckverfahren aufgebracht und anschließend eingebrannt. Die Länge der Sammelleiter 5.1, 5.2 entspricht annähernd der Ausdehnung der elektrische leitfähige Schicht 10. Beide Sammelleiter 5.1,5.2 verlaufen annähernd parallel.

An der oberen Seitenkante der Scheibe 100 ist eine Lichtquelle 14, beispielsweise eine Leuchtdiode (LED) angeordnet. Die Lichtquelle 14 kann im eingeschalteten Zustand Licht in das Substrat 1 über dessen Seitenkante einkoppeln. Auf einer Oberfläche IV des Substrats 1 ist ein Beleuchtungsmittel 8 in Form eines Lichtablenkmittels 15 angeordnet. Über das Lichtablenkmittel 15 kann das Licht der Lichtquelle 14 das Substrat 1 verlassen und dadurch den Berührungsbereich 3.1 der Schaltfläche 3 markieren. Es können auch zwei Lichtquellen 14 Licht in das Substrat 1 einkoppeln, mit beispielsweise zwei verschiedenen Farben. Durch die verschiedenen Farben kann beispielsweise der Schaltzustand der Heizfunktion über den Heizbereich visualisiert werden.

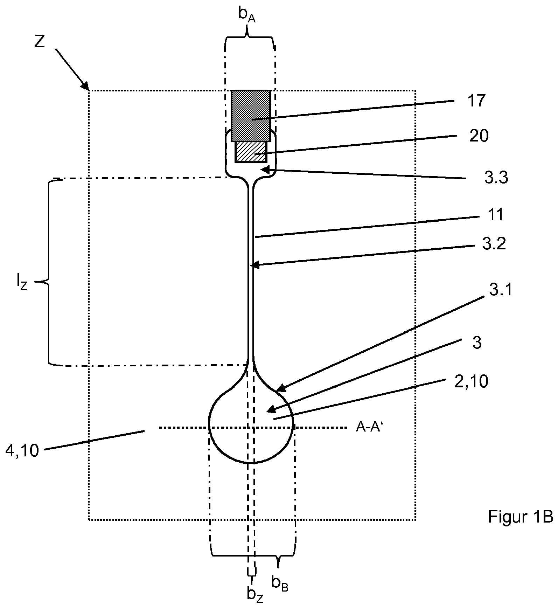

Figur 1B zeigt eine vergrößerte Darstellung des Ausschnitts Z aus Figur 1A in der Ebene der Schaltfläche 3. Die Schaltfläche 3 umfasst einen Berührungsbereich 3.1, der annähernd tropfenförmig ausgebildet ist und in einen Zuleitungsbereich 3.2 übergeht. Tropfenförmig bedeutet hier, dass der Berührungsbereich 3.1 im Wesentlichen kreisförmig ist und sich an einer Seite trichterförmig zum Zuleitungsbereich 3.2 hin verjüngt. Die Breite b_{B} des Berührungsbereichs 3.1 beträgt beispielsweise 40 mm. Die Breite bz des Zuleitungsbereichs 3.2 beträgt beispielsweise 1 mm. Der Zuleitungsbereich 3.2 ist mit einem Anschlussbereich 3.3 verbunden. Der Anschlussbereich 3.3 hat eine quadratische Form mit abgerundeten Ecken und einer Kantenlänge b_{A} von beispielsweise 12 mm. Die Länge l_{Z} des Zuleitungsbereichs 3.2 beträgt etwa 48 mm. Das Verhältnis von b_{Z}:b_{B} beträgt etwa 1:20.

Der Anschlussbereich 3.3 ist über eine elektrische Leitungsverbindung 20 mit einem Folienleiter 17 elektrisch leitend verbunden. Der Folienleiter 17 besteht beispielsweise aus einer 50 µm dicken Kupferfolie und ist beispielsweise außerhalb der Anschlussbereichs 3.3 mit einer Polyimidschicht isoliert. Dadurch kann der Folienleiter 17 ohne elektrischen Kurzschluss über den Sammelleiter 5.2 hinweg über den oberen Rand der Scheibe 100 hinausgeführt werden. Es versteht sich, dass die elektrische Verbindung des Anschlussbereichs 3.3 nach außen auch über isolierte Drähte oder über einen Bereich, in dem der Sammelleiter 5.2 unterbrochen ist, nach außen geführt werden kann.

Der Folienleiter 17 ist hier beispielsweise außerhalb der Scheibe 100 mit einer kapazitiven Sensorelektronik 30 verbunden, die Kapazitätsänderungen des Schaltbereichs 10 gegenüber "Erde" misst und in Abhängigkeit eines Schwellwerts ein Schaltsignal über den Anschlusspunkt 19, beispielsweise an den CAN-Bus eines Fahrzeugs weitergibt. Über das Schaltsignal können beliebige Funktionen im Fahrzeug geschaltet werden, beispielsweise auch die Spannungsquelle 6 und damit die elektrische Beheizung der Scheibe 100 über den Heizbereich 4.

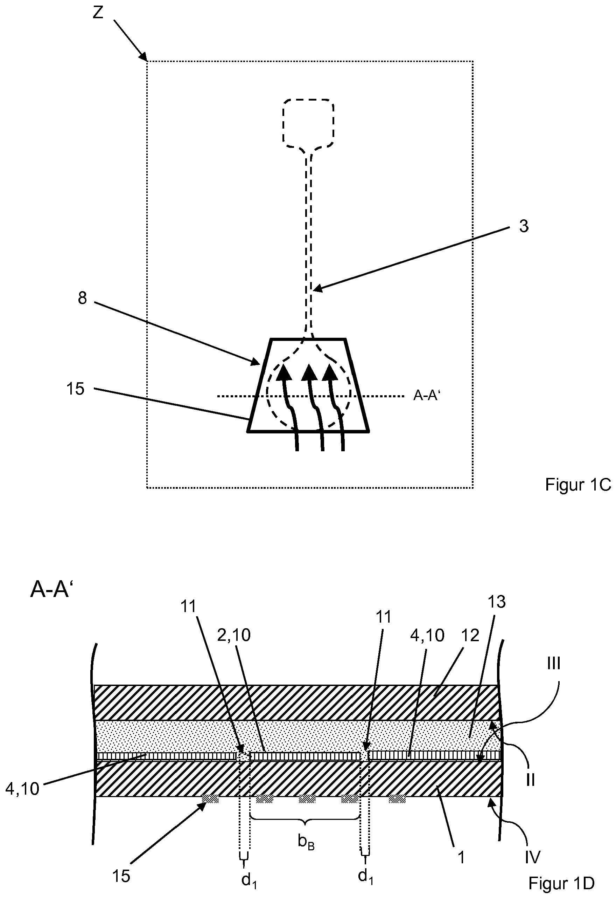

In Figur 1 C ist eine vergrößerte Darstellung des Ausschnitts Z aus Figur 1A in der Ebene der Lichtablenkmittel 15 dargestellt. Das Lichtablenkmittel 15 ist auf der Oberfläche IV des Substrats 1 angeordnet. Das Lichtablenkmittel 15 ist hier beispielsweise als aufgeraute Stelle der Oberfläche IV ausgebildet und weist das Symbol einer beheizten Windschutz-scheibe auf. Das Lichtablenkmittel 15 ist dabei in Durchsichtrichtung gesehen über der Schaltfläche 3 angeordnet und markiert den Berührungsbereich 3.1 der Schaltfläche 3. Das Lichtablenkmittel 15 kann derart gestaltet sein, dass es bei Tageslicht kaum sichtbar ist. Alternativ kann das Lichtablenkmittel 15 derart gestaltet sein, dass es bei Tageslicht gut sichtbar ist. Nach Einschalten der Lichtquelle 14 kann Licht über das Lichtablenkmittel 15 aus dem Substrat 1 austreten und ein Nutzer der Scheibe kann die Position des Lichtablenkmittels 15 auch bei Nacht gut erkennen. Gleichzeitig oder alternativ, kann durch das Lichtablenkmittel 15 eine Information, beispielsweise der Schaltzustand der Heizfunktion der Scheibe visualisiert werden.

In Figur 1D ist eine Querschnittsdarstellung entlang der Schnittlinie A-A' aus Figur 1A. Die Scheibe 100 umfasst hier beispielsweise ein Substrat 1 und eine Deckscheibe 12, die über eine thermoplastische Zwischenschicht 13 miteinander verbunden sind. Die Scheibe 100 ist beispielsweise eine Fahrzeugscheibe und insbesondere die Windschutzscheibe eines Personenkraftwagens. Das Substrat 1 ist beispielsweise dafür vorgesehen, in Einbaulage dem Innenraum zugewandt zu sein. Das heißt, die Seite IV des Substrats 1 ist vom Innenraum aus zugänglich, wogegen Seite I der Deckscheibe 12 nach außen weist. Substrat 1 und Deckscheibe 12 bestehen beispielsweise aus Natron-Kalkglas. Die Dicke des Substrats 1 beträgt beispielsweise 1,6 mm und die Dicke der Deckscheibe 12 beträgt 2,1 mm. Es versteht sich, dass Substrat 1 und Deckscheibe 12 beliebige Dicken aufweisen können und beispielsweise auch gleich dick ausgebildet sein können. Die thermoplastische Zwischenschicht 13 besteht aus Polyvinylbutyral (PVB) und weist eine Dicke von 0,76 mm auf. Auf der innenseitigen Oberfläche III des Substrats 1 ist die elektrisch leitfähige Schicht 10 aufgebracht.

Die elektrisch leitfähige Schicht 10 erstreckt sich beispielsweise über die gesamte Oberfläche III Substrats 1 abzüglich eines umlaufenden rahmenförmigen unbeschichteten Bereichs mit einer Breite von 8 mm. Der unbeschichtete Bereich dient der elektrischen Isolierung zwischen der spannungsführenden, elektrisch leitfähigen Schicht 10 und der Fahrzeugkarosserie. Der unbeschichtete Bereich ist durch Verkleben mit der Zwischen-schicht 8 hermetisch versiegelt, um die elektrisch leitfähige Schicht 10 vor Beschädigungen und Korrosion zu schützen.

Zur elektrischen Kontaktierung des Heizbereichs 4 der elektrisch leitfähigen Schicht 10 ist jeweils ein erster Sammelleiter 5.1 im unteren Randbereich und ein weiterer, zweiter Sammelleiter 5.2 im oberen Randbereich auf der elektrisch leitfähige Schicht 2 angeordnet. Die Sammelleiter 5.1, 5.2 enthalten beispielsweise Silberpartikel und wurden im Siebdruckverfahren aufgebracht und anschließend eingebrannt. Die Länge der Sammelleiter 5.1, 5.2 entspricht annähernd der Ausdehnung des Heizbereichs 4.

Wird an die Sammelleiter 5.1 und 5.2 eine elektrische Spannung angelegt, so fließt ein gleichmäßiger Strom durch die elektrisch leitfähige Schicht 2 des Heizbereichs 4 zwischen den Sammelleitern 5.1,5.2. Auf jedem Sammelleiter 5.1,5.2 ist ungefähr mittig ein Folien-leiter 17 angeordnet. Der Folienleiter 17 ist über eine Kontaktfläche mit dem Sammelleiter 5.1,5.2 elektrisch leitend verbunden, beispielsweise mittels einer Lotmasse, eines elektrisch leitfähigen Klebstoffs oder durch einfaches Aufliegen und Andruck innerhalb der Scheibe 100. Der Folienleiter 17 enthält beispielsweise eine verzinnte Kupferfolie mit einer Breite von 10 mm und einer Dicke von 0,3 mm. Die Sammelleiter 5.1,5.2 sind über die Folienleiter 17 über Zuleitungen 18 mit einer Spannungsquelle 6 verbunden, welche eine für Kraftfahrzeuge übliche Bordspannung, bevorzugt von 12 V bis 15 V und beispielsweise etwa 14 V bereitstellt. Alternativ kann die Spannungsquelle 6 auch höhere Spannungen aufweisen, beispielsweise von 35 V bis 45 V und insbesondere 42 V.

Die Sammelleiter 5.1,5.2 haben im dargestellten Beispiel eine konstante Dicke von beispielsweise etwa 10 µm und einen konstanten spezifische Widerstand von beispielsweise 2.3 µOhm•cm.

In einer besonders vorteilhaften Ausgestaltung der erfindungsgemäßen Scheibe 100 weist die Längsrichtung des Zuleitungsbereichs 3.2 der Schaltfläche 3 einen Winkel α von beispielsweise 0,5° zur mittleren Richtung des Strompfads 7 auf. Dadurch wird der Stromfluss des Heizstroms bei Anlegen einer Spannung an die Sammelleiter 5.1,5.2 nur geringfügig durch den Zuleitungsbereich 3.2 gestört. Der Zuleitungsbereich 3.2 kann daher beliebig lang gewählt werden, ohne dass der Verlauf des Heizstroms nennenswert gestört wird und ohne dass lokale Überhitzungen, sogenannte Hotspots, auf der Scheibe 100 auftreten.

Wird die Scheibe 100 beispielsweise als Windschutzscheibe in einem Kraftfahrzeug verwendet, kann die Länge des Zuleitungsbereichs 3.2 so gewählt werden, dass der Fahrer des Fahrzeugs oder der Beifahrer den Berührungsbereich 3.1 der Schaltfläche 3 bequem erreichen kann.

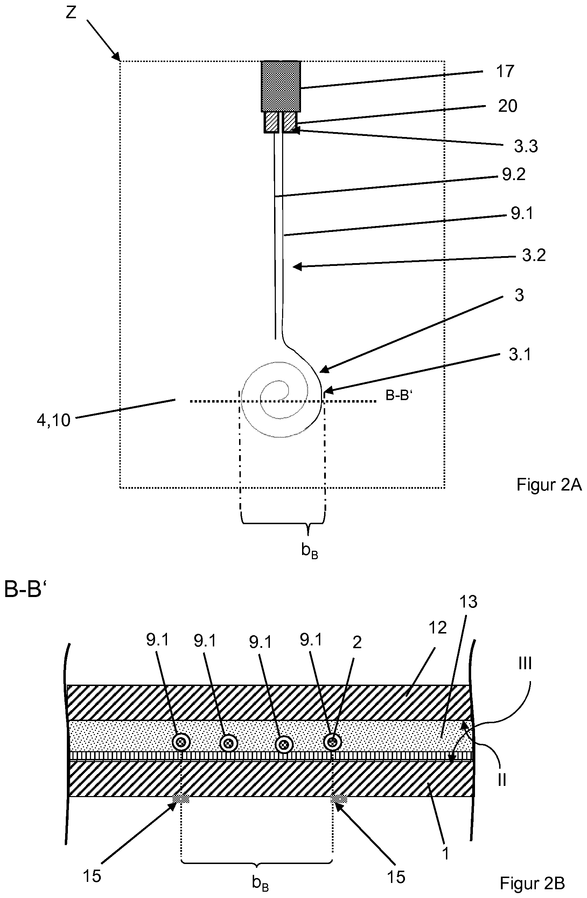

Figur 2A zeigt eine alternative Ausgestaltung einer erfindungsgemäßen Scheibe 100 in einer vergrößerten Darstellung des Ausschnitts Z aus Figur 1A. Die Schaltfläche 3 wird hier beispielsweise durch die elektrisch leitfähige Struktur 2 eines metallischen Drahts 9.1 gebildet. Der Draht 9.1 ist an einem Ende kreisrund gebogen und geht in eine Spirale mit sich verringerndem Radius über. Der Draht 9.1 bildet dort einen Berührungsbereich 3.1 aus. Die Scheibe 100 weist zusätzlich einen zweiten Draht 9.2 auf, der parallel zum Anschlussbereich 3.2 der Schaltfläche 3 verläuft. Die Drähte 9.1,9.2 sind mit Folienleitern 17 nach außen elektrisch verbunden und mit einer Sensorelektronik 30 verbindbar. Die Sensorelektronik 30 ist beispielsweise dazu geeignet eine Kapazitätsänderung zwischen den beiden Drähten 9.1,9.2 zu messen, wenn die Scheibe 100 in der unmittelbaren Umgebung der Schaltfläche 3 berührt wird. Die Drähte 9.1,9.2 haben beispielsweise einen Durchmesser von 70 µm und weisen eine elektrisch isolierende Ummantelung auf. Die Breite b_{B} und die Länge l_{b} des Berührungsbereichs 3.1 beträgt beispielsweise maximal 40 mm. Der Zuleitungsbereich 3.2 ist mit einem Anschlussbereich 3.3 verbunden. Der übrige Aufbau der Scheibe 100 entspricht beispielsweise dem Aufbau der Scheibe 100 aus Figur 1A.

Figur 2B zeigt eine Querschnittsdarstellung des Ausführungsbeispiels nach Figur 2A entlang der Schnittlinie B-B'. Der metallische Draht 9.1 weist beispielsweise eine elektrisch isolierende Ummantelung auf und ist hier beispielsweise zwischen der elektrisch leitfähigen Schicht 10 des Heizbereichs 4 und der Zwischenschicht 13 angeordnet. Durch die elektrisch isolierende Ummantelung wird ein elektrischer Stromfluss zwischen dem Draht 9.1 und dem Heizbereich 4 verhindert.

In einer besonders vorteilhaften Ausgestaltung der erfindungsgemäßen Scheibe 100 kann der Draht als Lichtablenkmittel 15 dienen und Licht, welches in das Substrat 1 oder die Deckscheibe 12 oder eine Zwischenschicht 13 eingekoppelt wurde, auskoppeln.

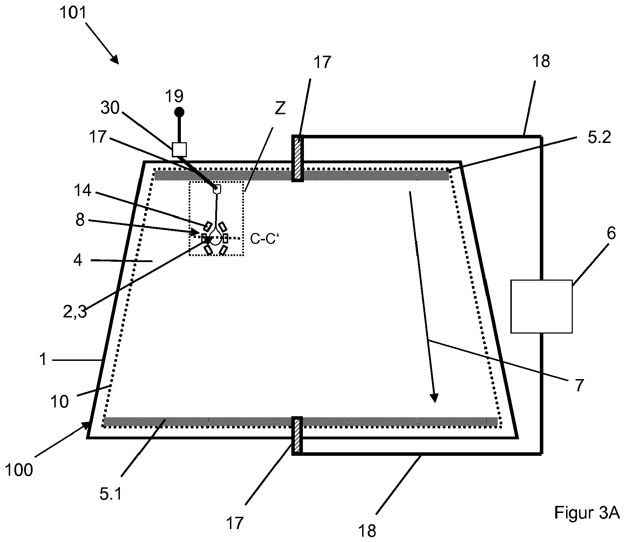

Figur 3A zeigt eine alternative Ausgestaltung einer erfindungsgemäßen Scheibenanordnung 101 mit einer Draufsicht auf eine erfindungsgemäße Scheibe 100, wobei die Beleuchtungsmittel 8 durch Lichtquellen 14, beispielsweise eine LED oder eine flächig angeordnete OLED-Struktur, die unmittelbar im Berührungsbereich 3.1 der Schaltfläche 3 angeordnet sind. Ansonsten entspricht die Scheibe 100 dieses Ausgestaltungsbeispiels beispielsweise der Scheibe 100 aus Figur 1A.

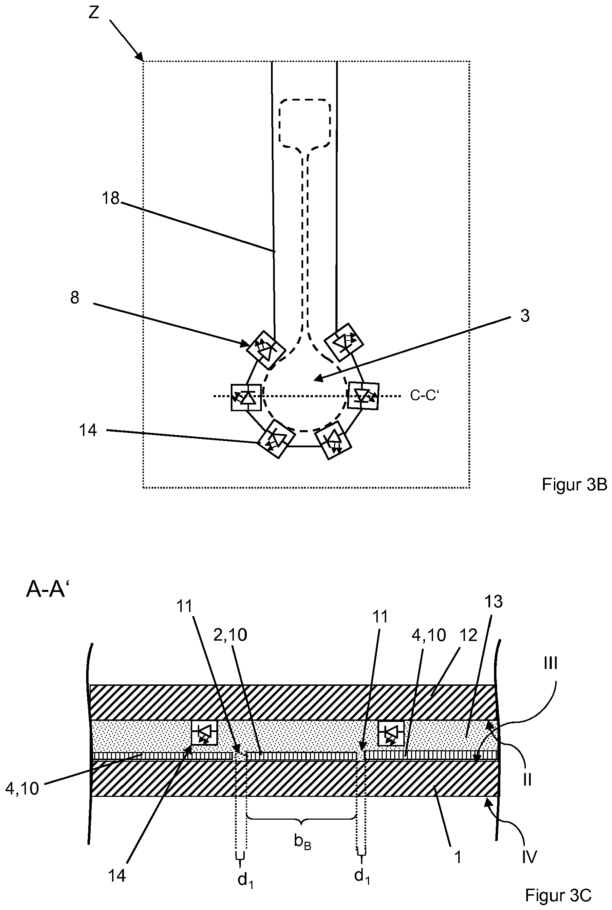

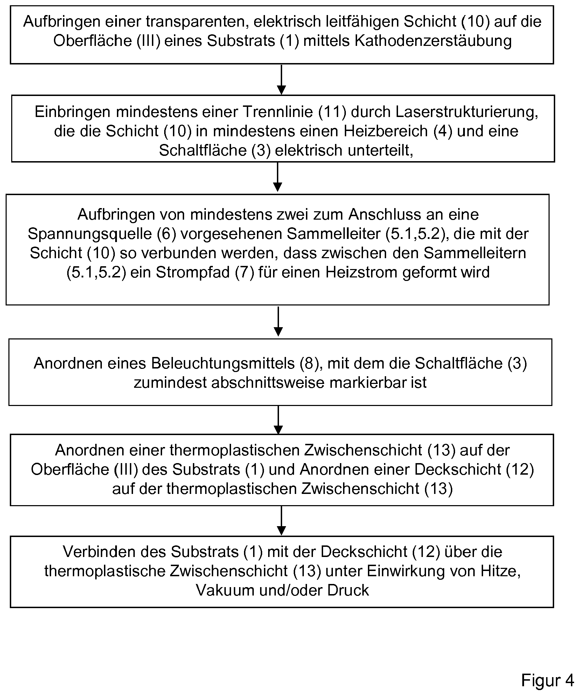

Figur 3B zeigt eine vergrößerte Darstellung des Ausschnitts Z aus Figur 4A. In diesem Ausgestaltungsbeispiel sind sechs Lichtquellen 15 zwischen der Zwischenschicht 13 und der Deckscheibe 12 einlaminiert. Die Lichtquellen 15 sind über Zuleitungen 18 elektrisch nach außen geführt und können außerhalb der Scheibe 100 mit einer Spannungsquelle verbunden werden.

Figur 3C zeigt dazu eine Querschnittsdarstellung entlang der Schnittlinie C-C' aus Figur 4A. In diesem Ausgestaltungsbeispiel wird der Berührungsbereich 3.1 der Schaltfläche 3 aktiv beleuchtet. Es versteht sich, dass die Lichtquellen 15 auch auf der Oberfläche I der Deckscheibe 12 oder auf der Oberfläche IV des Substrats 1 oder in Aussparungen des Substrats 1 oder der Deckscheibe 12 angeordnet sein können.

In einer besonders vorteilhaften Ausgestaltung der erfindungsgemäßen Scheibe 100 wird die elektrisch leitfähige Schicht 10 durch weitere Trennlinien unterteilt, die Zuleitungen 18 ausbilden, mit denen die Lichtquellen 14 untereinander und nach außen elektrisch verbunden sind.

Es versteht sich, dass die hier dargestellten Ausgestaltungsbeispiele auch anstelle eines Heizbereichs 4 mit einer elektrisch leitfähigen Schicht 10 auch einen Heizbereich mit einzelnen Heizdrähten, die die Sammelleiter 5.1 und 5.2 miteinander verbinden, ausgestaltet sein kann.

Figur 5 zeigt ein Flussdiagramm eines Ausführungsbeispiels des erfindungsgemäßen Verfahrens zur Herstellung einer elektrisch beheizbaren Scheibe 100 mit Schaltbereich 10.

Die erfindungsgemäße Scheibe 100 nach den Figuren 1-3 weist eine Schaltfläche 3 auf, die beispielsweise mit einer kapazitiven Sensorelektronik 30 verbindbar ist. Gleichzeitig weist die Scheibe 100 einen elektrisch beheizbaren Heizbereich 4 auf, wobei die Heizfunktion und die Heizleistungsverteilung durch die Schaltfläche 3 nicht oder nur geringfügig beeinträchtigt wird.

Dieses Ergebnis war für den Fachmann unerwartet und überraschend.

### Bezugszeichenliste:

- 100: Scheibe mit beleuchteter Schaltfläche
- 101: Scheibenanordnung
- 1: transparentes Substrat
- 2: elektrisch leitfähige Struktur
- 3: Schaltfläche
- 3.1: Berührungsbereich
- 3.2: Zuleitungsbereich
- 3.3: Anschlussbereich
- 4: Heizbereich
- 5.1, 5.2: Sammelleiter
- 6: Spannungsquelle
- 7: Strompfad
- 8: Beleuchtungsmittel
- 9.1,9.2: Draht
- 10: elektrisch leitfähige Schicht
- 11: Trennlinie
- 12: Deckscheibe
- 13: Zwischenschicht
- 14: Lichtquelle (LED)
- 15: Lichtablenkmittel
- 16: Sensorelektronik
- 17: Flachleiter
- 18: Zuleitung
- 19: Anschlusspunkt
- 20: elektrische Leitungsverbindung
- 30: Sensorelektronik
- II: Oberfläche der Deckscheibe 12
- III: Oberfläche des Substrats 1
- IV: Oberfläche des Substrats 1
- b_{A}: Breite des Anschlussbereichs 3.3
- b_{B}: Breite des Berührungsbereichs 3.1
- b_{Z}: Breite des Zuleitungsbereichs 3.2
- d₁: Breite der Trennlinie 11
- l_{A}: Länge des Anschlussbereichs 3.3
- l_{B}: Länge Berührungsbereichs 3.1
- l_{Z}: Länge des Zuleitungsbereichs 3.2
- A-A': Schnittlinie
- B-B': Schnittlinie
- C-C': Schnittlinie
- Z: Ausschnitt

## Patentansprüche

1. Scheibe (100) mit beleuchteter Schaltfläche (3) und Heizfunktion, mindestens umfassend:
- ein transparentes Substrat (1), wobei das Substrat (1) über mindestens eine Zwischenschicht (13) mit einer Deckscheibe (12) verbunden ist,
- einen Heizbereich (4), der mit mindestens zwei zum Anschluss an eine Spannungsquelle (6) vorgesehene Sammelleiter (5.1,5.2) so verbunden ist, dass zwischen den Sammelleitern (5.1,5.2) ein Strompfad (7) für einen Heizstrom geformt ist,
- eine elektrisch leitfähige Struktur (2), die eine Schaltfläche (3) ausbildet und die mit einer Sensorelektronik verbindbar ist und
- ein Beleuchtungsmittel (8), mit dem die Schaltfläche (3) markierbar ist,
wobei das Beleuchtungsmittel (8) eine Lichtquelle (14) umfasst, bevorzugt eine LED oder eine OLED,
**dadurch gekennzeichnet, dass**
die Lichtquelle (14) Licht in das Substrat (1), die Zwischenschicht (13) und/oder die Deckscheibe (12) einkoppelt und an der Seitenkante des Substrats (1) und/oder der Seitenkante der Deckscheibe (12), oder in einer Öffnung des Substrats (1) oder der Deckscheibe (12) angeordnet ist,
wobei mindestens ein Lichtablenkmittel (15), in dem vom Licht der Lichtquelle (14) bestrahlten Bereich des Substrats (1), der Zwischenschicht (13) oder der Deckscheibe (12) angeordnet ist und mindestens eine Struktur zur Lichtstreuung umfasst, die in unmittelbarer Umgebung der Schaltfläche (3) angeordnet ist und Licht aus dem Substrat (1), der Zwischenschicht (13) oder der Deckscheibe (12) auskoppelt.

2. Scheibe (100) nach Anspruch 1, wobei die Lichtquelle (14) in der unmittelbaren Umgebung der Schaltfläche (3) angeordnet ist.

3. Scheibe (100) nach Anspruch 1 oder 2, wobei die Struktur zur Lichtstreuung Partikel, Punktraster, Aufkleber, Anlagerungen, Einkerbungen, Einritzungen, Strichraster, Aufdrucke und/oder Siebdrucke umfasst.

4. Scheibe (100) nach einem der Ansprüche 1 bis 3, wobei die Lichtquelle (14) zwei Spannungsversorgungsanschlüsse aufweist, die über elektrische Zuleitungen (18) mit einer Spannungsquelle (6) verbindbar sind und die elektrischen Zuleitungen (18) bevorzugt durch Trennlinien (11) von der elektrisch leitfähigen Schicht (10) abgeteilt sind.

5. Scheibe (100) nach Anspruch 4, wobei die Spannungsversorgungsanschlüsse mit der Spannungsversorgung (6) des Heizbereichs (4) verbunden sind, bevorzugt über Drähte oder über einen Teilbereich der elektrisch leitfähigen Schicht (10).

6. Scheibe (100) nach einem der Ansprüche 1 bis 5, wobei der Heizbereich (4) eine transparente, elektrisch leitfähige Schicht (10) aufweist.

7. Scheibe (100) nach Anspruch 6, wobei die elektrisch leitfähige Struktur (2) und der Heizbereich (4) durch mindestens eine Trennlinie (11) von der transparenten, elektrisch leitfähigen Schicht (10) elektrisch unterteilt sind.

8. Scheibe (100) nach einem der Ansprüche 1 bis 5, wobei der Heizbereich (4) mindestens einen Heizdraht und/oder mindestens eine gedruckte Heizstruktur aus einem elektrisch leitfähigen Material aufweist.

9. Scheibe (100) nach einem der Ansprüche 1 bis 8, wobei die elektrisch leitfähige Struktur (2) mindestens ein lineares elektrisch leitfähiges Element, bevorzugt einen metallischen Draht (9.1,9.2) mit einem Durchmesser von ≤ 0,25 mm aufweist.

10. Scheibenanordnung (101), umfassend:
- eine erfindungsgemäße Scheibe (100) mit beleuchteter Schaltfläche (3) und Heizfunktion nach einen der Ansprüche 1 bis 9,
- mindestens eine Sensorelektronik (30) und mindestens eine Spannungsquelle (6), die mit der Schaltfläche (3), dem Heizbereich (4) und dem Beleuchtungsmittel (8) verbunden ist,
wobei die Sensorelektronik (30) derart ausgebildet ist, dass über eine Berührung der Schaltfläche (3) durch einen Menschen ein Schaltsignal zur Steuerung der Heiz-funktion ausgegeben wird und das Beleuchtungsmittel (8) einen Schaltzustand der Heizfunktion, beispielsweise "Ein" oder "Aus", anzeigt.

11. Verfahren zur Herstellung einer Scheibe (100) mit beleuchteter Schaltfläche (3) und Heizfunktion nach einem der Ansprüche 1 bis 9, wobei zumindest
(a) Aufbringen einer elektrisch leitfähigen Schicht (10) auf eine Oberfläche (III) eines transparenten Substrats (1),
(b) Einbringen mindestens einer Trennlinie (11), die die Schicht (10) in mindestens einen Heizbereich (4) und mindestens eine elektrisch leitfähige Struktur (2), die eine Schaltfläche (3) ausbildet, elektrisch unterteilt,
(c) Aufbringen von mindestens zwei zum Anschluss an eine Spannungsquelle (6) vorgesehene Sammelleiter (5.1, 5.2), die mit der Schicht (10) des Heizbereichs (4) so verbunden werden, dass zwischen den Sammelleitern (5.1,5.2) ein Strompfad (7) für einen Heizstrom geformt wird, und
(d) Anordnen eines Beleuchtungsmittels (8), mit dem die Schaltfläche (3) zumindest abschnittsweise markierbar ist.

12. Verwendung einer Scheibe (100) mit beleuchteter Schaltfläche (3) und Heizfunktion gemäß einem der Ansprüche 1 bis 9 als funktionales und/oder dekoratives Einzel-stück und/oder als Einbauteil in Möbeln und Geräten, insbesondere elektronischen Geräten mit Kühl- oder Heizfunktion, zur Verglasung von Gebäuden, insbesondere im Zugangs- oder Fensterbereich, oder zur Verglasung in einem Fahrzeug für den Verkehr auf dem Lande, in der Luft oder zu Wasser, insbesondere in Kraftfahrzeugen, Bussen, Straßenbahnen, U-Bahnen und Zügen zur Personenbeförderung und für den öffentlichen Nah- und Fernverkehr, beispielsweise als Fahrzeugtür und insbesondere als Windschutzscheibe.

## Claims

1. Pane (100) having an illuminated switch surface (3) and a heating function, comprising at least:
- a transparent substrate (1), wherein the substrate (1) is bonded via at least one intermediate layer (13) to a cover pane (12),
- a heating zone (4) that is connected to at least two busbars (5.1,5.2) intended for connecting to a voltage source (6) such that a current path (7) for a heating current is formed between the busbars (5.1,5.2),
- an electrically conductive structure (2) that forms a switch surface (3) and that can be connected to sensor electronics assembly, and
- an illumination means (8), with which the switch surface (3) can be marked,
wherein the illumination means (8) includes a light source (14), preferably an LED or an OLED,
**characterized in that** the light source (14) couples light into the substrate (1), the intermediate layer (13) and/or the cover pane (12) and is arranged at the lateral edge of the substrate (1) and/or the lateral edge of the cover pane (12), or is arranged in an opening of the substrate (1) or of the cover pane (12),
wherein at least one light deflection means (15) is arranged in the zone of the substrate (1) irradiated by the light of the light source (14), the intermediate layer (13), or the cover pane (12) and includes at least one structure for light scattering that is arranged in the immediate vicinity of the switch surface (3) and couples light out of the substrate (1), the intermediate layer (13), or the cover pane (12).

2. Pane (100) according to claim 1, wherein the light source (14) is arranged in the immediate vicinity of the switch surface (3).

3. Pane (100) according to claim 1 or 2, wherein the structure for light scattering includes particles, point grids, stickers, deposits, indentations, scratches, line grids, imprints, and/or silkscreen prints.

4. Pane (100) according to one of claims 1 through 3, wherein the light source (14) has two power supply connectors that can be connected to a voltage source (6) via electrical supply lines (18) and the electrical supply lines (18) are preferably separated from the electrically conductive layer (10) by dividing lines (11).

5. Pane (100) according to claim 4, wherein the power supply connectors are connected to the voltage supply (6) of the heating zone (4), preferably via wires or via part of the electrically conductive layer (10).

6. Pane (100) according to one of claims 1 through 5, wherein the heating zone (4) has a transparent, electrically conductive layer (10).

7. Pane (100) according to claim 6, wherein the electrically conductive structure (2) and the heating zone (4) are electrically partitioned from the transparent, electrically conductive layer (10) by at least one dividing line (11).

8. Pane (100) according to one of claims 1 through 5, wherein the heating zone (4) has at least one heating wire and/or at least one printed heating structure made of an electrically conductive material.

9. Pane (100) according to one of claims 1 through 8, wherein the electrically conductive structure (2) has at least one linear electrically conductive element, preferably a metal wire (9.1,9.2) with a diameter of ≤ 0.25 mm.

10. Pane arrangement (101), comprising:
- a pane (100) according to the invention with an illuminated switch surface (3) and a heating function according to one of claims 1 through 9,
- at least one sensor electronics assembly (30) and at least one voltage source (6) that is connected to the switch surface (3), to the heating zone (4), and to the illumination means (8),
wherein the sensor electronics assembly (30) is configured such that a switch signal for controlling the heating function is sent by a touch of the switch surface (3) by a person and the illumination means (8) displays a switching state of the heating function, for example, "ON" or "OFF".

11. Method for producing a pane (100) with an illuminated switch surface (3) and a heating function according to one of claims 1 through 9, comprising at least
(a) applying an electrically conductive layer (10) on a surface (III) of a transparent substrate (1),
(b) introducing at least one dividing line (11) that electrically partitions the layer (10) into at least one heating zone (4) and at least one electrically conductive structure (2), which forms a switch surface (3),
(c) applying at least two busbars (5.1, 5.2) intended for connecting to a voltage source (6) that are connected to the layer (10) of the heating zone (4) such that a current path (7) for a heating current is formed between the busbars (5.1,5.2), and
(d) arranging an illumination means (8), with which the switch surface (3) can be identified, at least in sections.

12. Use of a pane (100) with an illuminated switch surface (3) and a heating function according to one of claims 1 through 9 as a functional and/or decorative individual piece and/or as a built-in component in furniture and devices, in particular electronic devices with a cooling or heating function, for glazing of buildings, in particular in the access or window area, or for glazing in a motor vehicle for travel on land, in the air, or on water, in particular in automobiles, buses, streetcars, subways, and trains for passenger service and for public short and long distance travel, for example, as a motor vehicle door and, in particular, as a windshield.

## Revendications

1. Vitre (100) avec un bouton éclairé (3) et une fonction de chauffage, comprenant au moins :
- un substrat transparent (1) où le substrat (1) est relié à une plaque de recouvrement (12) par au moins pendant une couche intermédiaire (13),
- une zone de chauffage (4), qui est reliée à au moins deux conducteurs collectifs (5.1, 5.2) prévus pour être connectés à une source de tension (6) de telle manière, qu'entre les conducteurs collectifs (5.1, 5.2) un trajet de courant (7) pour un courant de chauffage est formé,
- une structure conductrice d'électricité (2), qui forme un bouton (3) et qui est connectable à un circuit électronique de détection, et
- un moyen d'éclairage (8), avec lequel le bouton (3) peut être marqué,
où le moyen d'éclairage (8) comprend une source de lumière (14), de préférence une LED ou une OLED, **caractérisée en ce que** la source de lumière (14) injecte de la lumière dans le substrat (1), la couche intermédiaire (13) et/ou la plaque de recouvrement (12) et est disposée sur le bord latéral du substrat (1) et/ou le bord latéral de la plaque de recouvrement (12), ou dans une ouverture du substrat (1) ou de la plaque de recouvrement (12), où au moins un dispositif de déviation de la lumière (15) est disposé dans la zone du substrat (1) de la couche intermédiaire (13) ou de la plaque de recouvrement (12) irradiée par la lumière de la source de lumière (14), et comprend au moins une structure pour la diffusion de la lumière, qui est disposée dans les environs immédiats du bouton (3 et injecte de la lumière émanant du substrat (1), de la couche intermédiaire (13) ou de la plaque de recouvrement (12).

2. Vitre (100) selon la revendication 1, où la source de lumière (14) est disposée à proximité immédiate du bouton (3).

3. Vitre (100) selon la revendication 1 ou 2, où la structure pour la diffusion de la lumière comprend des particules, des matrices de points, des autocollants, des dépôts, des rainures, des entailles, des trames réticulées, des surimpressions et/ou des sérigraphies.

4. Vitre (100) selon l'une des revendications 1 à 3, où la source de lumière (14) présente deux bornes d'alimentation en tension qui peuvent être connectées par l'intermédiaire de lignes d'alimentation électriques (18) avec une source de tension (6) et les lignes d'alimentation électriques (18) sont séparées de la couche conductrice d'électricité (10), de préférence par des lignes de séparation (11).

5. Vitre (100) selon la revendication 4, où les bornes d'alimentation en tension sont connectées à la source d'alimentation (6) de la zone de chauffage (4), de préférence par des fils ou par un sous-ensemble de la couche conductrice (10) d'électricité.

6. Vitre (100) selon l'une des revendications 1 à 5, où la zone de chauffage (4) présente une couche transparente, conductrice d'électricité (10).

7. Vitre (100) selon la revendication 6, où la structure conductrice d'électricité (2) et la zone de chauffage (4) sont séparées électriquement par au moins une ligne de séparation (11) de la couche transparente, conductrice d'électricité (10).

8. Vitre (100) selon une des revendications 1 ou 2, où la zone de chauffage (4) présente au moins un fil de chauffage et/ou au moins une structure de chauffage imprimée faite d'un matériau conducteur d'électricité.

9. Vitre (100) selon l'une des revendications 1 à 8, où la structure conductrice d'électricité (2) présente au moins un élément linéaire électriquement conducteur (2), de préférence un fil métallique (9.1, 9.2) avec un diamètre de ≤0,25 mm.

10. Arrangement de vitres (101), qui comprend:
- une vitre selon l'invention (100) avec un bouton éclairé (3) et une fonction de chauffage selon l'une des revendications 1 à 9,
- au moins un circuit électronique de détection (30) et au moins une source de tension (6), qui est connectée au bouton (3), la zone de chauffage (4) et le moyen d'éclairage (8),
où le circuit électronique de détection (30) est formé de telle manière, que par une pression sur le bouton (3) par un être humain un signal de commutation pour commander la fonction de chauffage est délivré et le moyen d'éclairage (8) affiche un état de commutation de la fonction de chauffage, par exemple, « marche » ou « arrêt».

11. Procédé de fabrication d'une vitre (100) avec un bouton éclairé (3) et une fonction de chauffage selon l'une des revendications 1 à 9, comprenant au moins
(a) l'application d'une couche conductrice (10) sur une surface (III) d'un substrat transparent (1),
(b) l'introduction d'au moins une ligne de séparation (11), qui subdivise électriquement la couche (10) en au moins une zone de chauffage (4) et au moins une structure conductrice (2), qui forme un bouton (3),
(c) l'application d'au moins deux conducteurs collectifs (5.1, 5.2) prévus pour être connectés à une source de tension (6), qui sont reliés à la couche (10) de la zone de chauffage (4) de telle manière, qu'un trajet de courant (7) est formé entre les conducteurs collectifs (5.1, 5.2) pour un courant de chauffage, et
(d) placement d'un moyen d'éclairage (8), avec lequel le bouton (3) peut être marqué au moins par sections.

12. Utilisation d'une vitre (100) avec un bouton éclairé (3) et une fonction de chauffage selon l'une des revendications 1 à 9 comme pièce fonctionnelle et/ou décoratif et/ou comme pièce dans le cadre de l'installation dans le mobilier et les équipements, en particulier les équipements électroniques avec une fonction de refroidissement ou de chauffage, pour le vitrage des bâtiments, en particulier dans les zones d'accès ou des fenêtres ou pour le vitrage dans un véhicule pour la circulation sur la terre, dans l'air ou dans l'eau, en particulier dans les véhicules automobiles, les autobus, les tramways, les métros et les trains pour le transport de voyageurs et pour les transports publics locaux et interurbains, par exemple comme porte de véhicule et en particulier comme pare-brise.
